# EUROPEAN PATENT APPLICATION

(11) **EP 4 793 776 A2**
(43) Date of publication of application: **19.08.2026**
(21) Application number: 26152719.6
(22) Date of filing: 19.01.2026
(51) Int. Cl.: G06F 11/10

(54) **SYSTEMS AND METHODS FOR HIGH PERFORMANCE READ WITH ON-DIE CIRCUITS**

(30) Priority: 27.01.2025 US 202519038544
(71) Applicant: Kioxia Corporation, Tokyo (JP)
(72) Inventor: Steiner, Avi, 69719 Tel Aviv (IL); Kanter, Ofir, 69719 Tel Aviv (IL); Weingarten, Hanan, 69719 Tel Aviv (IL)
(74) Representative: Hoffmann Eitle

(57) **Abstract**

The present disclosure relates to a flash memory system including a controller and one or more memory integrated circuits. Each of the one or more memory integrated circuits may include a circuit and a non-volatile memory comprising one or more blocks. Each block may include a plurality of rows of cells. The circuit may perform a read operation on a page of the non-volatile memory. The circuit may decode data of the page. In response to determining that decoding of the data fails, the controller may read the data from the non-volatile memory. The controller may decode the data.

## Description

The present arrangements relate generally to system and method for performing operations of a flash memory, and more particularly to system and method for performing operations of a flash memory using on-die circuits (e.g., error correction code (ECC) circuits or read circuits in a memory integrated circuit).

### BACKGROUND

As the number and types of computing devices continue to expand, so does the demand for memory used by such devices. Memory includes volatile memory (e.g. RAM) and non-volatile memory. One popular type of non-volatile memory is flash memory or NAND-type flash. A NAND flash memory array includes rows and columns (strings) of cells. A cell may include a transistor.

There may be low read performance issues and/or low reliability issues in NAND flash devices because a controller of a NAND flash memory system is burdened with multiple tasks, including performing signal processing operations for read thresholds tracking and decoding during continuous reads from the memory, for example. Additionally, the controller may need to manage rare failures that occur under higher stress conditions. This multitasking may prevent the controller from achieving high read performance and/or high reliability.

### SUMMARY

The present arrangements relate to system and method for performing operations of a flash memory using on-die circuits (e.g., ECC circuits or read circuits in a memory integrated circuit).

According to other aspects, arrangements provide a flash memory system including a controller and one or more memory integrated circuits. Each of the one or more memory integrated circuits may include a circuit and a non-volatile memory comprising one or more blocks. Each block may include a plurality of rows of cells. The circuit may be configured to perform operations on the non-volatile memory. The circuit may be configured to perform a read operation on a page of the non-volatile memory. The circuit may be configured to decode data of the page. In response to determining that decoding of the data fails, the controller may be configured to read the data from the non-volatile memory. The controller may be configured to decode the data.

According to certain aspects, arrangements provide a method for performing operations in a flash memory system including a controller and one or more memory integrated circuits. Each integrated circuit may include a circuit and a non-volatile memory. The non-volatile memory may include one or more blocks, each block comprising a plurality of rows of cells. The method may include performing, by the circuit, a read operation on a page of the non-volatile memory. The method may include decoding, by the circuit, data of the page. The method may include in response to determining that decoding of the data fails, reading, by the controller, the data from the non-volatile memory. The method may include decoding, by the controller, the data.

### BRIEF DESCRIPTION OF THE DRAWINGS

These and other aspects and features of the present arrangements will become apparent to those ordinarily skilled in the art upon review of the following description of specific arrangements in conjunction with the accompanying figures, wherein:
FIG. 1 illustrates an example of a voltage threshold distribution according to some arrangements;
FIG. 2 illustrates an example process of read flow in a conventional flash device;
FIG. 3 illustrates an example of a fully-connected (FC) deep neural network (DNN) according to some arrangements;
FIG. 4 illustrates an example flash memory system in a conventional flash device;
FIG. 5 illustrates an example flash memory system including a controller and NAND dies with one or more circuits, according to some arrangements;
FIG. 6A and FIG. 6B illustrate example memory integrated circuits according to some arrangements;
FIG. 6C illustrates an example memory integrated circuit according to some arrangements;
FIG. 7 is a block diagram illustrating an example flash memory system according to some arrangements;
FIG. 8 is a flowchart illustrating an example methodology for performing read operations according to some arrangements;
FIG. 9 illustrates an example structure of error correction code (ECC) code, according to some arrangements;
FIG. 10 is a flowchart illustrating an example methodology for performing read operations using on-die circuits (e.g., ECC circuits or read circuits in a memory integrated circuit), according to some arrangements;
FIG. 11 is a flowchart illustrating another example methodology for performing read operations using on-die circuits, according to some arrangements;
FIG. 12 is a flowchart illustrating yet another example methodology for performing read operations using on-die circuits, according to some arrangements;
FIG. 13 is a flowchart illustrating an example methodology for performing a patrol read using on-die circuits, according to some arrangements;
FIG. 14 is a flowchart illustrating another example methodology for performing a copyback operation using on-die circuits, according to some arrangements, according to some arrangements;
FIG. 15A and FIG. 15B are timing diagrams illustrating timing of copyback operations using on-die circuits, according to some arrangements;
FIG. 16 is a flowchart illustrating another example methodology for dynamic inter-cell-interference (ICI) estimation and compensation, according to some arrangements;
FIG. 17 is a flowchart illustrating an example methodology for dynamic inter-cell-interference (ICI) estimation and compensation using on-die circuits, according to some arrangements;
FIG. 18A to FIG. 18C illustrate diagrams illustrating example simulation results of performance of a flash memory system using on-die circuits, according to some arrangements; and
FIG. 19 is a flowchart illustrating an example methodology for performing operations of a flash memory using circuits in memory integrated circuits (or on-die circuits), according to some arrangements.

### DETAILED DESCRIPTION

According to certain aspects, arrangements in the present disclosure relate to techniques for performing operations of a flash memory using on-die circuits (e.g., error correction code (ECC) circuits or read circuits in a memory integrated circuit).

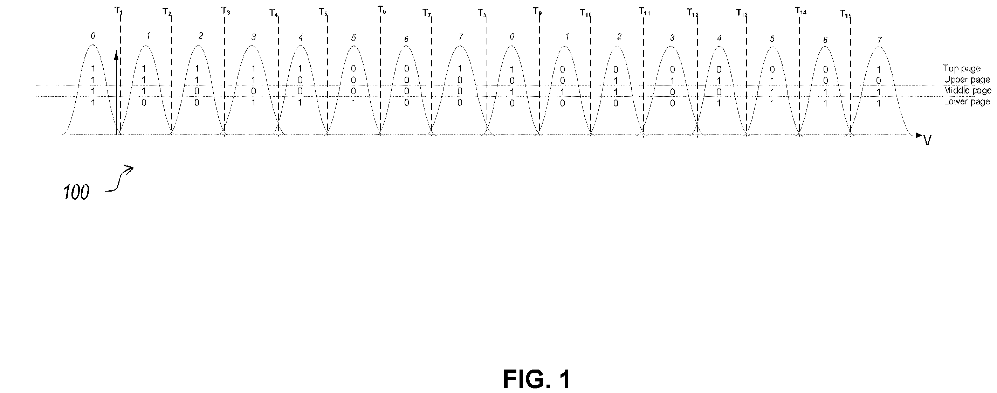

FIG. 1 illustrates an example of a voltage threshold distribution 100 according to some arrangements. FIG. 1 illustrates a voltage threshold distribution of a 4 bits per cell (bpc) flash memory device, i.e., quadruple level cells (QLC) with 16 programmable states. The voltage threshold (VT) distribution includes 16 lobes. A lower page read requires using thresholds T1, T3, T6 and T12. For reading the middle page, the read thresholds T2, T8, T11 and T13 are used. For reading the upper page, the read thresholds T4, T10 and T14 are used. For reading the top page, thresholds T5, T7, T9 and T15 are used. The lower most lobe (0) is known as the erase level. Retention, program/erase cycles and read disturb can change the voltage threshold distribution (e.g., voltage threshold distribution shown in FIG. 1) in different ways and create various bit error rate (BER) conditions. For each condition, different read thresholds can be chosen for achieving lowest BER after READ operation. Thus, the read thresholds of a target page in a NAND device are estimated repeatedly during the device life cycle in order to maintain high read performance and benefit from an efficient read flow with low latency that avoids SB decoding (soft-bit decoding) as much as possible.

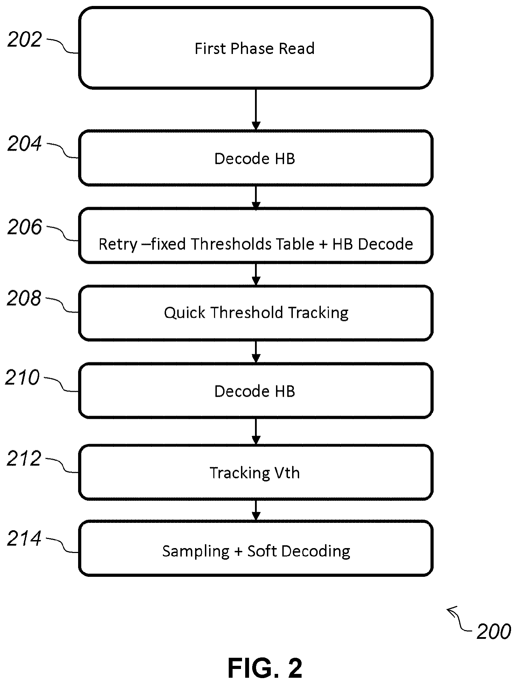

FIG. 2 illustrates an example (simplified) process 200 of read flow in a conventional flash device. FIG. 2 describes typical stages for read-retry in case of failures. On default, a flash memory system (e.g., a controller, a read circuit or an error correction code (ECC) decoder of a NAND flash device) may perform first-phase reads, which refers to reads with preconfigured (or pre-defined) initial default thresholds (step 202). The system (e.g., a controller of a NAND flash device) may decode a read by a hard-bit (HB) decoder, e.g., a decoder that operates on binary input (step 204). In case of a decode failure, the controller may refer to a shift table that holds several thresholds candidates. The candidate thresholds are also referred to as a "retry-fixed thresholds table". On a first (read) failure on a page, the controller may choose or select a first table entry, configure the NAND thresholds based on the first entry, read the same page again, and perform HB decoding (step 206). In case of a second failure, the process may be repeated with other shift table candidates until success on HB decoding. On a HB decode success, the shift table entry (e.g., a threshold candidate used for the read corresponding to the HB decode success) may be saved in a table called history table (HT) that is available per block. A pointer to the HT may be used for future reoccurring reads from same block, to allow the controller to use the same thresholds that are compatible to a current stress of this block. If decoding fails with all shift table candidates, then the controller may perform a quick threshold tracking (QT) to estimate the optimal thresholds of the current row (step 208). The QT may perform a few mock reads with fixed thresholds, from which a histogram is computed. An estimator (e.g., controller, or software, firmware, hardware, or a combination thereof) may use the histogram for estimating the current thresholds. The estimator can be a linear estimator or a DNN based estimator. The controller may configure estimated thresholds to NAND, and perform a read-retry, followed by HB decoding (step 210). If HB decoding fails, then the controller may perform a higher complexity threshold tracking (step 212), e.g., pre-soft tracking (PST), followed by sampling and/or soft decoding (step 214).

In some arrangements of the present disclosure, a system (e.g., a NAND flash device or a controller thereof) can perform a row-to-row (R2R) estimation. According to the physical characteristics of the NAND, there is a typical voltage-threshold (VT) probability distribution for every NAND row per block. On 3D-NANDs there may be a typical distribution per word-line (WL), where rows within a given WL may have a similar VT distribution (referred to as a row-VT distribution). Therefore, if thresholds are known for a target row as a result of activating an estimation process on that row, then it might be useful to use this result and estimate thresholds of any other row, from a given row (e.g., the target row) and thresholds of the given row, by using the typical row-VT distribution, thereby saving the cost and/or overhead of thresholds-estimation per row.

According to some arrangements of the present disclosure, a row-to-row (R2R) estimator can be trained in order to provide a minimized retry probability, when a controller performs first-phase reads. The R2R estimator can receive as input a target row, and provide optimal shifts (e.g., optimal in terms of reducing a retry probability) to apply with respect to a first-phase read shift. In some arrangements, the first-phase read shift may be zero shifts of default thresholds. The R2R estimator can be implemented in various manners including (1) a look-up-table (LUT), which provides the shifts per threshold and per row; (2) a linear based estimator; and/or (3) a deep neural network (DNN) based estimator. In some arrangements, a LUT-based R2R estimator for first-phase reads may be fully optimized to support all required stresses to provide lowest read-retry rate (RRR) with first-phase-reads using a LUT (e.g., a LUT which provides the shifts per threshold and per row). As a NAND density increases, the blocks may become larger, due to having more layers and strings per block. The advantage of using a DNN-based R2R estimator is relatively smaller memory requirements for such large blocks. Thus, a DNN-based R2R estimator can perform effectively a compression of a LUT. Such DNN-based compression is also scalable to future NAND devices.

In some arrangements, an R2R estimator can be trained for a fixed thresholds set, which are used within a read retry flow (or a read retry process/operation). That is, the R2R estimator can have a specific trained configuration for every entry of a retry-fixed thresholds table, where each entry represents another subset of stress conditions that are supported by the controller. For example, in case of data-retention (DR) stress, thresholds can be optimized over a specific row that is referred to as "reference row". A table (e.g., LUT for R2R) can be optimized on this stress as well, to convert the reference row thresholds to every other row under this DR stress.

In some arrangements, the R2R estimator can be described as: ${TH}_{r 2 r} \left(row, ShiftIdx\right) = {TH}_{ref} \left(ShiftIdx\right) + {LUT}_{ShiftIdx} \left(row\right)$

For every shift index, a LUT can be defined per row to provide target thresholds. A shift index may be a retry-fixed thresholds table index which is an index to a retry-fixed thresholds table. An "index" or "shift index" refers to a retry pointer that is saved per block. The retry pointer can be associated with a stress condition. Holding a LUT per shift-index means that there is a different R2R estimator per read-retry. The row index can be an entry pointer to the LUT. This can adapt the R2R estimation according to a stress condition. In some arrangements, first-phase reads may correspond to ShiftIdx=0. This LUT-based implementation may be memory inefficient. In a LUT implementation, a suboptimal solution which saves memory can use a common LUT for all shift indexes, as follows: ${TH}_{r 2 r} \left(row, ShiftIdx\right) = {TH}_{ref} \left(ShiftIdx\right) + LUT \left(row\right)$
where an identical LUT can be used for all shift indices. The LUT can also be the same table for the case of read after quick threshold tracking (QT). The reference thresholds in the case of read after QT may be mapped from a failed row to a (common) reference row using the LUT, and then the thresholds value may be compressed by clustering to the nearest cluster (e.g., using K-means clustering), and only the index cluster center can be saved as the ShiftIdx. This compression can significantly reduce the memory requirements per threshold tracking operation, allow for using a compact history table (HT) to save the state of a block after failure, and/or allow near optimal thresholds for all rows using the R2R estimator with the mapped ShiftIdx after QT.

In some arrangements, the R2R estimator can be implemented by a DNN, which may receive the ShiftIdx as an input feature, together with a row index (e.g., row index of a target row), and provide the thresholds to be used for read of the target row. The ShiftIdx can be available from the history table per block. ${TH}_{r 2 r} \left(row\right) = DNN \left(ShiftIdx, row\right)$

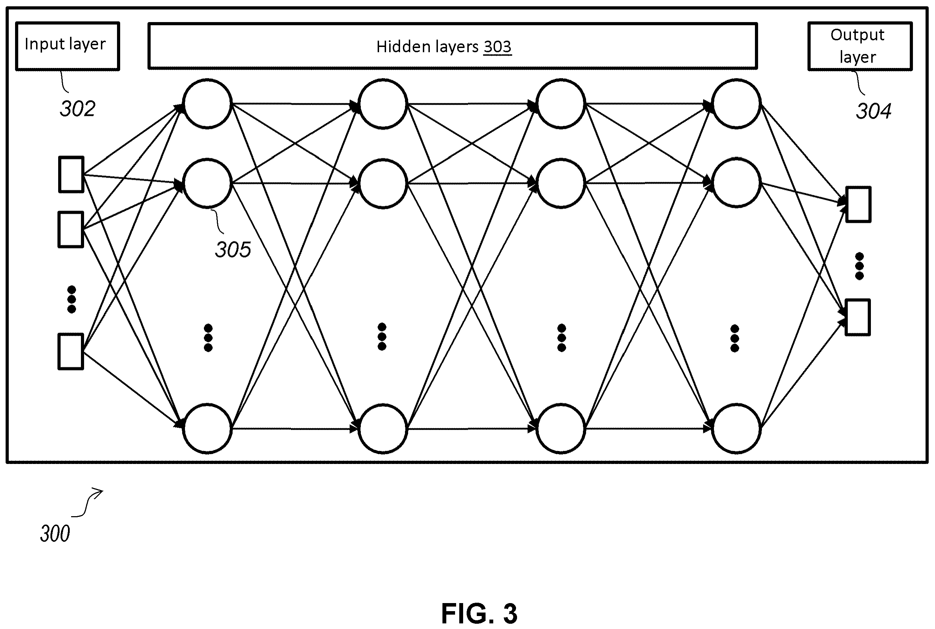

FIG. 3 illustrates an example of a fully-connected (FC) deep neural network (DNN) 300 for a row-to-row (R2R) estimator according to some arrangements. The example DNN may include an input layer 302, one or more hidden layers 303, and/or an output layer 304. In the example DNN shown in FIG. 3, the input layer 302 can include a target row index (e.g., index to a target row) and a shift index. The output layer 304 can include an estimated thresholds for the target row.

In some arrangements of the present disclosure, a row index can be represented by entity embedding (EE) which is a result of a 1-hot input training for a DNN estimator (e.g., DNN-based R2R estimator). In some arrangements, entity embedding for the row index can be implemented or obtained by training a 1-hot input of row index that is fully connected to a few neurons of a DNN (e.g., neurons 305). The entity embedding values per row can be saved in a LUT which is used as input instead of a 1-hot input. For example, the LUT can map a row index to values of neurons that are connected to the original 1-hot input. The LUT can be used to provide the neuron values per row index instead of the 1-hot input and the neuron's fully connect weights. This can save a lot of memory, and can reduce implementation complexity. This LUT-based implementation of the entity embedding (EE) is very robust for large NAND blocks with many rows. Since the entity embedding (EE) implementation saves memory and reduces implementation complexity, the EE can be used for large NAND blocks. The EE can be an alternative form for implementing row index encoding to neuron values.

In some arrangements, a DNN (or a DNN-based R2R estimator) can be trained with input thresholds which correspond to (1) optimal thresholds of a selected reference row, or (2) QT thresholds of the selected reference row. In some arrangements, the R2R thresholds obtained by the DNN-based R2R estimator can be given by ${TH}_{r 2 r} \left(row\right) = DNN \left(ShiftIdx, row, {TH}_{HT - ref}\right)$
where the ShiftIdx (shift index) can be a pointer to the phase/retry stages of the history table. The shift index can correspond to the number of retry or the current stress condition (e.g., retry index). This retry index can be a subset of a history table (HT). The HT can be a generalized form of saving thresholds per block corresponding to different stress conditions. The ShiftIdx can be a pointer to the generalized HT. Initial few entries (e.g., low index values) of the HT can correspond to a few ordered start-of-life (SOL) set of stresses, hence the shift-index can be used as input to the DNN. The *TH_{HT-ret}* input can correspond to the thresholds extracted from the history table, in case that QT is activated on this block. The *TH_{HT-ref}* input can be reference thresholds from HT that are closest to the estimated thresholds by a QT operation while *TH_{HT-ref}* is read-flow dependent.

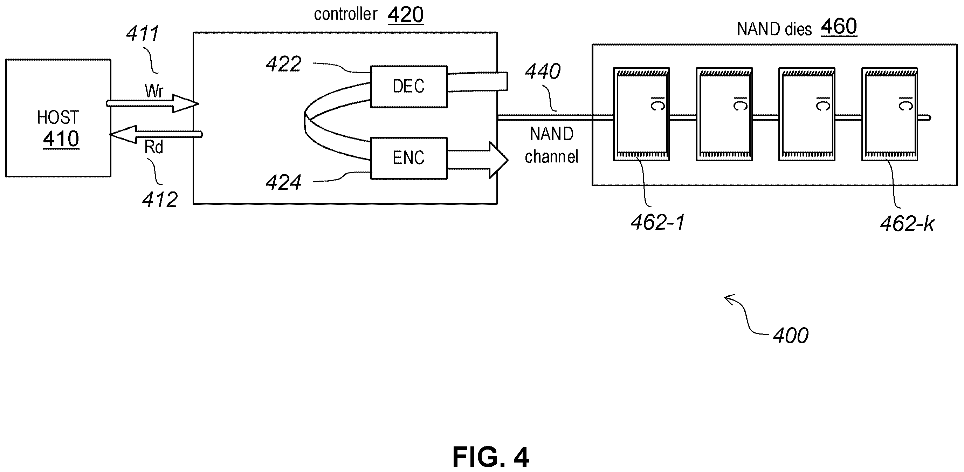

FIG. 4 illustrates an example flash memory system 400 in a conventional flash device. The system 400 may include a host 410 (e.g., a computing device), a controller 420, and/or NAND flash memory 460. The NAND flash memory 460 may include a plurality of NAND dies or a plurality of integrated circuits 462-1, ..., 462-k (k is an integer greater than 0). The host 410 may send commands (e.g., write command 411, read command 412, etc.) to the controller 420, and/or receive a result of commands (e.g., a result of a write operation, or data read from the memory 460). ECC encoder and/or decoder and read circuits (e.g., read digital signal processor (DSP)) are implemented on the controller side. In response to receiving commands (e.g., write command 411, read command 412, etc.) from the host 410, the controller 420 may encode 424 and write data to the NAND flash memory 460, and/or may read data from the NAND flash memory 460 and decode the data 422. The controller 420 is connected to the plurality of NAND dies 460 via some common NAND channel 440 such that the plurality of NAND dies are connected on the same NAND channel. With this configuration, the controller 420 and the NAND channel 440 may be burdened with multiple tasks (e.g., NAND operations).

In one aspect, there may be low read performance issues and/or low reliability issues in NAND flash devices because a controller of a NAND flash memory system is burdened with multiple tasks (see FIG. 4), including performing signal processing operations for read thresholds tracking and decoding during continuous reads from the memory, for example. Additionally, the controller may need to manage rare failures that occur under higher stress conditions. This multitasking may prevent the controller from achieving high read performance and/or high reliability.

To solve these problems, according to certain aspects, arrangements in the present disclosure relate to systems and methods for improving performance of NAND operations (e.g., read operation) with on-die circuits (e.g., on-die read circuits) in a NAND flash devices. The on-die circuits refer to one or more circuits (e.g., ECC circuits or read DSP circuits) that are implemented, disposed, or formed in a NAND die or in an integrated circuit. In some arrangements, implementations of NAND operations/functions (e.g., ECC or read DSP) can be split between a controller and a NAND die (or NAND dies). The on-die circuits may include a (simplified) hard decoder, and/or a (simplified) soft bit decoder. The hard decoder refers to a type of ECC decoder that uses hard-decision decoding techniques, e.g., making a binary decision on each bit of the received data, determining whether it is a 0 or a 1, based on a fixed threshold. The soft bit decoder (or "soft decoder") refers to a type of decoder (e.g., ECC decoder) that uses soft information to enhance error correction capabilities. Soft information is obtained by performing multiple reads of the memory cells at different word-line voltages, which provides a range of confidence levels for each bit. In some arrangements, the on-die soft bit decoder may have sampling capability.

In some arrangements, a flash memory system can use on-die circuits to perform high performance read with low complexity NAND internal threshold tracking with read DSP operations for start-of-life (SOL). In some arrangements, the flash memory system can use on-die circuits to perform a patrol read without any data-out (e.g., data output from the on-die circuits to the controller). The patrol read refers to scanning the entire or portions of a NAND flash memory periodically to identify and/or resolve potential errors before they can cause data corruption or drive failure. In some arrangements, the threshold tracking for patrol read can be implemented or performed on die (e.g., on NAND dies or in memory integrated circuits), by performing mock reads and linear/DNN estimation of optimal thresholds (e.g., using DNN 300 for an R2R estimator). In this manner, the usual overhead of the controller due to the patrol read with high bandwidth of data transfer between controller and NAND can be reduced.

In some arrangements, patrol commands can perform mock reads, obtain a histogram as a result of the mock reads, and/or perform estimation operations (from the same histogram). The estimation operations can include (1) thresholds estimation and updates on a history table with the estimated thresholds, and/or (2) BER classification, e.g., detecting high BER and returning such status to the controller for later refresh scheduling.

In some arrangements, the flash memory system can use on-die circuits to perform (on-die) efficient copy-back operations with error correction, thereby allowing or implementing garbage collection without any data transfer between the controller and the NAND memory. Such on-die copy-back functionality can allow performing refresh operations to NAND blocks, by copying data from an "old" block to another block, while performing on-die error-correction.

In some arrangements, the flash memory system can use on-die circuits to perform dynamic inter-cell-interference (ICI) compensation. The dynamic ICI compensation can include (1) on-die optimal thresholds estimation per ICI state, and/or (2) performing read operations with estimated ICI compensation thresholds, and performing fast decoding.

In some arrangements, a flash memory system can include a controller and NAND dies with one or more circuits including one or more ECC circuits and/or one or more read (read DSP) circuits. The flash memory system may include a host (e.g., a computing device), a controller, and/or NAND flash memory. The NAND flash memory may include a plurality of NAND dies or a plurality of memory integrated circuits. The plurality of memory integrated circuits can include respective on-die circuits and respective memory (cell) arrays. The host may send commands (e.g., write command, read command, etc.) to the controller, and/or receive a result of commands (e.g., a result of a write operation, or data read from the memory). The controller may include at least one of a solid-state drive (SSD) controller, a software-enabled flash (SEF) controller, or a universal flash storage (UFS) controller. The controller may be a simplified controller compared with controllers of a conventional flash device (e.g., controller 420). In some arrangements, the simplified controller does not contain read circuits and/or ECC circuits that are implemented on NAND dies. The on-die circuits (e.g., circuits implemented or disposed in an integrated circuit) can implement DSP capabilities, and/or some ECC functionality. For example, if a simple low complexity decoder is implemented on die, then the decoder bandwidth requirements can be much lower than the controller decoder bandwidth. In general, a low complexity decoder can be implemented in a low gate-count hardware and can have a low decoding latency. Different decoding methods can mainly differ in their complexity. Usually higher complexity decoding can have better decode capabilities, e.g., succeed in correction of more errors. Since decoder per die can be activated simultaneously on all dies (e.g., all memory integrated circuits), read operations can be performed in parallel from all dies. In addition, each die (e.g., each memory integrated circuit) can perform internal read-DSP operations, such as thresholds tracking, or continuous row-to-row prediction, and/or dynamic ICI compensation, etc. The controller can be connected to the plurality of NAND dies via some common NAND channel (or connection) such that the plurality of NAND dies are connected on the same NAND channel. In some arrangements, the controller can communicate, via the NAND channel, with the plurality of dies or memory integrated circuits simultaneously. In some arrangements, the NAND channel or connection may be implemented at least one of asynchronous and synchronous interfaces, open NAND flash interface (ONFI), toggle mode double data rate (DDR), or multiplexed bus. In some arrangements, the host can communicate with the controller via a connection including at least one of peripheral component interconnect express (PCIe), serial ATA (SATA), universal serial bus (USB), or embedded multimedia card (eMMC), or non-volatile memory express (NVMe).

In some arrangements, a memory integrated circuit may include a substrate, a NAND memory array, and/or one or more circuits (e.g., one or more transistors). In some arrangements, the substrate can include Si wafers or any substrate that can be used in an integrated circuit. In some arrangements, the NAND memory array may include at least one of three-dimensional (3D) bit cost scaling (BiCS) NAND memory arrays, charge trap flash (CTF) NAND memory arrays, floating gate NAND memory arrays, or any NAND memory arrays that can be implemented in an integrated circuit. In some arrangements, the one or more circuits may include one or more transistors including at least one of bipolar junction transistors (BJT), field-effect transistors (FET), MOSFET (Metal-Oxide-Semiconductor Field-Effect Transistor; e.g., NMOS, PMOS, CMOS), FinFET (Fin Field-Effect Transistor), or any transistor that can be implemented in an integrated circuit. In some arrangements, the one or more circuits (or transistors) can implement DSP and ECC logic for performing NAND memory operations. In some arrangements, the one or more circuits (or transistors) can include a CMOS die for logic circuit implementation, which can include data latches per plane, sense amplifiers, charge pumps, program logic, trim registers, etc. In some arrangements, the CMOS circuit can be manufactured or produced in a different process than the memory array. In some arrangements, the one or more circuits (or transistors) and the memory array can be formed or disposed on same substrate.

In some arrangements, a memory integrated circuit may include a first substrate, a NAND memory array, a second substrate and/or one or more circuits (e.g., one or more transistors). In some arrangements, each of the first substrate and the second substrate can include Si wafers or any substrate that can be used in an integrated circuit. In some arrangements, the NAND memory array may include at least one of 3D-BiCS NAND memory arrays, CTF NAND memory arrays, floating gate NAND memory arrays, or any NAND memory arrays that can be implemented in an integrated circuit. In some arrangements, the one or more circuits can include one or more transistors including at least one of BJT, FET, MOSFET (e.g., NMOS, PMOS, CMOS), FinFET, or any transistor that can be implemented in an integrated circuit. In some arrangements, the one or more circuits (e.g., CMOS logic circuit) can be bonded to the NAND memory array. In some arrangements, as the memory array dimensions change and grow and become 3-dimensional, the CMOS logic can move to be under a vertical stack of memory cells instead of being alongside a NAND memory array. In some arrangements, depending on CMOS process and memory array capacity, more logic can be added to a CMOS circuit without increasing the total NAND memory die area, for example, as long as the CMOS circuit area is smaller than the memory array physical area size. In some arrangements, various logics for NAND operations (e.g., read-DSP and ECC logic) can be added to the NAND die in order to improve overall storage performance, for example, by potentially reducing power and bandwidth requirements on NAND die interface.

In some arrangements, the one or more circuits (e.g., CMOS logic circuit) can be bonded to the NAND memory array using a technology or method of CMOS directly bonded to array (CBA) based on Cu direct bonding process. The CBA method can include (1) forming CMOS peripheral circuit (CMOS) and a cell array on separate Si wafers, (2) forming Cu bonding pads on each surface, and (3) bonding between CMOS and cell array surfaces with Cu direct bonding process to fabricate 3D flash memory. CBA technology can eliminate high aspect ratio contacts(HARCs) which connect CMOS to cell array, and it is possible to use low resistance Cu line. In some arrangements, the one or more circuits (e.g., CMOS logic circuit) can be bonded to the NAND memory array using a process of CMOS under Array (CUA). In a CUA process, a memory array can be formed sequentially on CMOS. On the other hand, CBA technology can process both CMOS and cell array, individually.

In some arrangements, a memory integrated circuit may include one or more on-die circuits (logic circuits), a NAND memory array, and/or a page buffer (for storing a page of non-volatile memory). In some arrangements, the one or more on-die circuits can include at least one of an ECC circuit (or module), a read circuit (e.g., read DSP circuit), and/or a data buffer (for storing data for performing ECC and/or read operations). In some arrangements, the ECC circuit can be a simplified, light or partial ECC circuit (or module). A partial decoder can implement, for example, only hard decoding (of hard input), while a full decoder can perform soft decoding as well as hard decoding. In some arrangements, a partial decoder may be a partial hard-decoder that performs only iterative bounded-distance decoding (BDD), but does not perform advanced algorithms such as intersections enumeration/decoding, or safe-decoding. In some arrangements, the voltage domain VCC can be associated with the memory array and the logic circuit. In some arrangements, the voltage domain VCCQ can be associated with interface logic (e.g., output stage logic). In some arrangements, different voltage domain can be used for example for high speed input/output (I/O) which may be used for transferring data in the page buffer to a controller and vise-versa.

In some arrangements, a flash memory system can perform read operations using one or more on-die circuits (e.g., on-die ECC circuits and/or on-die read DSP circuits). In some arrangements, a first process (steps 1-1 to 1-12) for a read flow begins in step 1-1 by the one or more on-die circuits reading a next page. In some arrangements, steps 1-1 to step 1-7 can be implemented in or performed by the on-die circuits, while steps 1-8 to step 1-12 can be implemented in or performed by a controller of the flash memory system.

In some arrangements, in step 1-2, the one or more on-die circuits can perform a HT-Get operation to extract a HTIndex (e.g., index to a history table) that keeps the state of the block and points to the type of read on a first stage (e.g., first phase read). In step 1-3, the one or more on-die circuits can perform an R2R estimator. In step 1-4, the one or more on-die circuits can perform a read operation and perform hard bit (HB) decoding. For example, when a command of page read is issued from a host, the controller can translate the command physical address, and issue a read and decode command to NAND. The target page can be read into the NAND's internal page buffer. In some arrangements, the one or more on-die circuits can activate a fast (HB) decoder. In some arrangements, the fast HB decoder can be a low complexity decoder as will be described in the following sections. In response to determining that the decoding succeeds, the NAND (or the one or more on-die circuits) can generate a decode success status to the controller, and the controller can read out the successfully decoded data, without the redundancy bits, which are not needed. In response to determining that the fast decoding fails, the controller may issue an internal tracking command (if the target block did not have updated read thresholds), and in step 1-5, the one or more on-die circuits can perform quick-training thresholds tracking (QT) on the NAND die to estimate optimal thresholds to the target page. After performing QT, in step 1-6, the one or more on-die circuits can compute an HTIndex using the HT-Set operation, which can be implemented by a K-means search algorithm. In step 1-7, the one or more on-die circuits can update the HTIndex. Using the updated thresholds, another read of the target page is performed into an internal NAND page buffer, and the fast HB decoder (of the one or more on-die circuits) can be activated.

In some arrangements, in step 1-5, in response to determining that HB decoding fails, the controller can read raw data (e.g., payload and redundancy data) from NAND. In some arrangements, in step 1-8, the controller can perform HB decoding on the NAND raw data-out (transferred from the NAND). In step 1-9, if HB decoding fails, then the controller may perform a QT to estimate the optimal thresholds of the current row. The QT may perform a few mock reads with fixed thresholds, from which a histogram is computed. An estimator (e.g., controller, or software, firmware, hardware, or a combination thereof) may use the histogram for estimating the current thresholds. The estimator can be a linear estimator or a DNN based estimator. In step 1-10, the controller can perform HB decoding. In step 1-11, if HB decoding fails, then the controller may perform a higher complexity threshold tracking, e.g., pre-soft tracking (PST), followed by sampling and/or soft decoding in step 1-12.

In some arrangements, in step 1-5, in response to determining that HB decoding succeeds, the NAND (or the one or more on-die circuits) can generate a decode success status to the controller, and the controller can read out the successfully decoded data, without the redundancy bits, which are not needed. in response to determining that the fast decoding fails for the 2^{nd} time, a decoder-fail status can be read by the controller, and the controller can issue a data-out command from NAND to read-out the raw-data including the redundancy bits. Then, in step 1-8, the controller can activate a higher complexity decoder, which has higher capability, and may decode more errors than the fast-decoder on NAND die (e.g., the one or more on-die circuits). On success, the decoded data can be sent from the controller to the host computer. Otherwise, the controller may activate a higher accuracy thresholds tracking (quick threshold tracking) in step 1-9. In step 1-10, the controller can read the target page with updated thresholds and HB decode with full capability on a decoder of the controller. In response to determining that the HB decoding fails, in step 1-11, the controller may issue and perform an even higher complexity threshold tracking, e.g., pre-soft tracking (PST), followed by soft decoding in step 1-12.

In some arrangements, during every event of threshold tracking (on-die or on controller), an updated set of thresholds for a target row can be computed. In some arrangements, the one or more on-die circuits can provide the thresholds as input to HT-Set function on the NAND-die (step 1-6), which can perform a row-to-row transformation to a common reference row, and then the one or more on-die circuits can compress the thresholds into an HT index that points to closest representative thresholds on HT-table (step 1-7). The HT index can be updated for the block, and can be used during any page read.

In some arrangements, one or more on-die circuits (e.g., on-die ECC circuits) can use an ECC code structure for half-folded product codes (HFPC) that can be used to encode data written to NAND memory. In some arrangements, each component of the ECC code can be a BCH code that corrects only a few errors, for which a simple low complexity hard decoder can be implemented on NAND-die (as the one or more on-die circuits).

In the ECC code structure, payload bits can be divided into a plurality of groups. For each group, redundancy bits can be generated. For example, given the payload bits, n number of redundance bits R1, R2, ..., Rn can be generated, and a codeword can include the payload bits concatenated by the redundancy bits.

HFPC is a turbo code, which is built of multiple small code components, where each code component can be for example a Bose-Chaudhuri-Hocquenghem (BCH) code. The number of code components *n* is determined by the correction capability of each component and the required code rate. For example, given *Dₘᵢₙ* per component, the correction capability of each component is *t* = (*Dₘᵢₙ* - 1)/2 and the amount of bits used for redundancy for each component is as follows: $r \left(c\right) = Q ∗ t$ where *Q* is the Galois field parameter for the BCH component defined over *GF*(2*^{Q}*)*.*

Given a specific code rate with total redundancy bits 'r' and error correction capability of each component t, and *GF*(2*^{Q}*)*,* the number of code component n is as follows:
$n = \frac{r}{r \left(c\right)} = \frac{r}{Q ∗ t}$

Main parts of BCH encoding/decoding implementation can be based on the Galois field (Q) value. For example, BCH encoding process, BCH syndrome calculation, and BCH solver circuits (Error Locator Polynomial (ELP) generation and solving) are implemented according to dedicated values of Q. In a conventional hardware implementation, the ECC circuits are implemented based on a single value of Q, since supporting multiple values of Q requires dedicated HW per each Q value, and this is expensive in term of gate-count complexity.

In order to provide flexibility and support a range of code rates with a specific HW, the number of code components 'n' is variable and configured according to the following equation:
$n = \frac{r}{Q ∗ t}$

During construction of HFPC code for a specific code rate, some constraints should be met. One constraint is that every code component length must be smaller than <2*^{Q}*.

In some arrangements, one or more on-die circuits (e.g., on-die ECC circuits) can use several decoding methods some of which are more simple and fast (compared with the other decoding methods), while other decoding methods are more complicated (compared with the other decoding methods). The differences between different decoding methods can include (1) error correction capability, (2) average power consumption, and/or (3) average latency.

In some arrangements, the one or more on-die circuits can use, as a decoding method, at least one of (1) a fast-decoding method, (2) a quick safe-decoding method, or (3) a reliability decoding method. In some arrangements, the fast-decoding method (e.g., bounded distance decoding (BDD)) may include iterative decoding of each component. Some of the packets may suggest a solution, and the error fixes can be implemented. During the iterative decoding process, the total number of errors can be reduced, until all the errors are fixed.

In some arrangements, the quick safe-decoding method may include iterative decoding of code components, considering the solution reliability of each code component. In case that the solution is reliable, the fixes can be implemented, and in case that the solution is not reliable enough, it can be rejected, and the iterative decoding can be continued without adopting the suggested fixes of the packet. Convergence of such safe decoding method may be slower compared to the fast-decoding method, but due to the "safe decoding approach", some of the false correction solution can be rejected, and as a result the error correction capability can be improved.

In some arrangements, the reliability decoding method can include safe decoding with soft scores that are computed during the evaluation of valid candidates, e.g., during intersections decoding, and initial decoding per component each iteration.

In some arrangements, a flash memory system can perform HB decoding of a single codeword using one or more on-die circuits (e.g., on-die ECC circuits and/or on-die read DSP circuits). In some arrangements, a second process for a read flow (steps 2-1 to 2-9) begins in step 2-1 by performing HB decoding. In step 2-2, the one or more on-die circuits can perform fast decoding (with limited complexity) on basic phase with intersections (e.g., intersections decoding, or a decoding flow for product codes). In some arrangements, HB decoding of a single codeword can be implemented in a combination of NAND (e.g., on-die circuits) and the controller of the flash memory system. In some arrangement, the one or more on-die circuits can perform decoding of a codeword on NAND die, using a low complexity fast decoding algorithm, such as BDD, but not limited thereto. For example, a more advanced intersections decoding may also be implemented on NAND (e.g., as an on-die ECC circuit) to provide improved capability under limited implementation complexity and latency limitations. In some arrangements, steps 2-1 to 2-3 can be implemented in or performed by the on-die circuits, while steps 2-4 to 2-9 can be implemented in or performed by a controller of the flash memory system.

In some arrangements, in step 2-3, the on-die circuits can determine whether the (fast) decoding fails or succeeds. In response to determining that the (fast) decoding fails, the controller can read raw data (e.g., payload and redundancy data) from NAND. For example, in case the decoding fails, the original (row) data (e.g., payload and redundancy data) from the NAND buffer can be transferred to the controller.

In some arrangements, in response to determining that the (fast) decoding succeeds, in step 2-5, the controller can determine that the decoding succeeds. When decoding succeeds, the corrected data (payload only) can be transferred from NAND to the controller, and the controller can transfer the data to a host computer without having to process the data on the decoder, as it contains no errors.

In some arrangements, in step 2-4, in response to reading the raw data from the on-die circuits, the controller can configure the next attempt of decoding as high reliability decoding (or safe decoding). The controller can perform higher complexity decoding, and may apply more than one decoding attempts, until decoding succeeds, or a maximal number of attempts is reached. It is noted that during the decoding operation in the controller, other NAND dies (e.g., the one or more on-die circuits) can continue decoding with their fast-decoders, and continue transferring clean payload data to the controller, while the controller is still decoding its input from a failed die.

In step 2-5, the controller can perform HB decoding. In step 2-6, the controller can determine whether the HB decoding fails or succeeds. In response to determining that the HB decoding succeeds, in step 2-6, the controller can determine that the decoding succeeds. In response to determining that the HB decoding fails, in step 2-7, the controller can determine whether the number of attempts reaches a predetermined maximum number of attempts. In response to determining that the number of attempts reaches the predetermined maximum number, in step 2-9, the controller can determine that decoding fails and end the second process. In response to determining that the number of attempts is less than the predetermined maximum number, the controller can proceed to step 2-4. In this manner, an algorithmic (e.g., algorithm for perform HB decoding of a single codeword) can be split between a NAND-die decoder (e.g., on-die ECC circuit) and a controller decoder (e.g., ECC circuit in the controller), which allows higher complexity decoding flows.

In some arrangements, a flash memory system can perform reliable page read operations using one or more on-die circuits (e.g., ECC circuits and/or on-die read DSP circuits). In some arrangements, a third process (step 3-1 to step 3-10) for a read flow begins in step 3-1 by using HT-Get to obtain thresholds to read a target page into internal NAND buffers. In some arrangements, the controller can request from NAND a reliable read command for a certain page (or smaller segment). For example, in NAND memory, a segment may refer to 4KB of data requested by host, which is a minimal request size. A NAND page size may be 16KB. The page can be read into internal NAND buffers (e.g., internal NAND buffers of a memory integrated circuit) while using threshold provided by the HT-Get function/operation. The HT-Get operation refers to an operation of extracting thresholds from a history table. For each block, there is a pointer called "HT index" that selects the corresponding current thresholds. These can be thresholds of a reference (common) row, which can be translated to the target row. This can be done with a row-to-row (R2R) estimator. The estimator may be same for all stresses, or may be optimized per stress condition which is associated with HT index.

In some arrangements, steps 3-1 to 3-4 can be implemented in or performed by the on-die circuits, while steps 3-5 to 3-10 can be implemented in or performed by a controller of the flash memory system.

In some arrangements, in step 3-2, the one or more on-die circuits can perform HB decoding with a low complexity (fast) decoder on NAND (e.g., low complexity decoder of the one or more on-die circuits). The page data in the internal NAND buffer can be decoded with the low complexity (fast) decoder. When decoding ends, a decode status (also referred to as "NAND-decode status") can be provided to the controller.

In some arrangements, in step 3-5, the controller can read a NAND-decode status, and in step 3-6, the controller can determine whether the HB decoding fails or succeeds. In response to determining that the HB decoding succeeds, the controller can read out data (e.g., payload only) from the NAND, and bypass decoding on the controller. In response to determining that the HB decoding fails, in step 3-8, the controller can determine whether an internal threshold tracking (e.g. threshold tracking performed by the one or more on-die circuits) is needed. In some arrangements, in response to the NAND-decode status indicating a success status, the NAND can send or transfer the corrected data (payload only) to the controller.

In some arrangements, in response to determining that an internal threshold tracking is needed, in step 3-3, the one or more on-die circuits can perform NAND internal thresholds tracking. In some arrangements, in response to the controller determining that a thresholds tracking has to be executed, the controller can issue a command for NAND internal thresholds tracking. This command can allow the NAND to compute updated thresholds by using for example a quick threshold tracking (QT) algorithm to estimate the optimal thresholds of a current row. In step 3-3, the one or more on-die circuits can perform the QT by performing a few mock reads with fixed predetermined thresholds, from which a histogram is computed. The histogram can be used for estimating the current thresholds by an estimator. The estimator can be a linear estimator or a DNN based estimator.

In step 3-4, the one or more on-die circuits can perform HT-Set (e.g., update the history table with thresholds obtained as a result of the internal threshold tracking) and proceed to step 3-1. The one or more on-die circuits can update the computed thresholds (from the internal threshold tracking) by the HT-Set function/operation. The HT-Set function/operation can determine the HT index that points to thresholds table entry with nearest thresholds. The HT-Set function/operation can perform a compression by finding the HT index, for example, with a K-means algorithm. In this manner, the computed thresholds can be used for reading the target page for the second time into the internal page buffer (step 3-1).

In some arrangements, in response to determining that an internal threshold tracking is not needed, in step 3-9, the controller can read out data or a full codeword (e.g., payload and redundancy data) from the NAND. In step 3-10, the controller can perform full-capability hard (HB) decoding on the full codeword. In some arrangements, on a decode fail status (in step 3-6), for the second time, in response to determining that the controller does not send a tracking command, in step 3-9, the controller can read the raw data as was read into internal buffer payload and redundancy, and, in step 3-10, decode the codeword with a different decoder, which has higher complexity and higher decoding capability and/or performs a full-capability decoding.

In some arrangements, a flash memory system can perform optimal thresholds read operations and decoding using one or more on-die circuits (e.g., ECC circuits and/or on-die read DSP circuits). In some arrangements, a fourth process (step 4-1 to step 4-11) for an optimal thresholds read flow begins in step 4-1 by performing N mock signal state reads with predetermined thresholds, from a target row. The one or more on-die circuits can read states from the N mock signal state reads into N internal buffers on NAND (e.g., N internal buffers of a memory integrated circuit). In some arrangements, steps 4-1 to 4-10 can be implemented in or performed by the on-die circuits, while step 4-11 can be implemented in or performed by a controller of the flash memory system.

In some arrangements, the controller can issue a command for a NAND internal thresholds tracking. In response to the command, in step 4-1, the one or more on-die circuits can compute updated thresholds by using, for example, a quick threshold tracking (QT) algorithm to estimate the optimal thresholds of a current row. The one or more on-die circuits can perform thresholds tracking estimation by (1) performing N single-state reads using N-predetermined mock threshold, and (2) reading single states from the N single-state reads, and storing the single states in N separate NAND internal buffers (e.g., N NAND internal buffers of a memory integrated circuit).

In some arrangements, in step 4-2, the one or more on-die circuits can compute a joint histogram H of VT distributions of all single state reads. From N the NAND internal buffers, the one or more on-die circuits can compute a histogram with N+1 states, denoted by H, where the number of states is N+1 due to having performed N single state reads. In some arrangements, the one or more on-die circuits for QLC device can perform 4 page reads in predetermined mock thresholds locations, and compute a 2^4=16 state histogram of the target row. In some arrangements, the read size can be even smaller than a full page for computational complexity limitation on NAND.

In some arrangements, in step 4-3, the one or more on-die circuits may estimate target page read thresholds from the histogram H to predict optimal thresholds using at least one of (1) a linear estimator, (2) a deep neural network (DNN)-based estimator, or (3) a LUT-based estimator. In some arrangements, the linear (precomputed) estimator can extract optimal row thresholds as follows:
${Ths}_{¯} = P * H$
where P is the linear estimator coefficients, and H is the computed histogram, and Ths are the estimated thresholds vector.

In some arrangements, the DNN-based estimator can provide higher accuracy (e.g., than the linear estimator) at the price of higher computational complexity. In some arrangements, the LUT-based estimator can be a direct simple solution that can map the histogram values to an HT index in a history table (also referred to as "HT table") to select a threshold set from the history table.

In some arrangements, in step 4-4, the one or more on-die circuits can provide the estimated thresholds as input to HT-Set function on the NAND-die (e.g., HT-Set function implemented in the one or more on-die circuits). In some arrangements, once the thresholds are estimated, the one or more on-die circuits can update the HT table index with the estimated thresholds by using the HT-Set function, which performs R2R and selection of index HT index that corresponds to thresholds that are closest to estimated thresholds (e.g., using K-means search). The HT-Set function can determine the HT index that points to thresholds table entry with nearest thresholds. The HT-Set function can perform a compression by finding the HT index, for example, with a K-means algorithm. In step 4-5, the one or more on-die circuits may read a target page using the estimated thresholds into internal buffers on NAND (e.g., internal buffers of a memory integrated circuit). The computed (or estimated) thresholds can be used for reading the target page for the second time into an internal page buffer (e.g., an internal page buffer of a memory integrated circuit).

In step 4-6, the one or more on-die circuits can perform HB decoding with a low complexity (fast) decoder on NAND (e.g., low complexity decoder of the one or more on-die circuits). The page data in the internal NAND buffer can be decoded with the low complexity (fast) decoder. When decoding ends, a decode status (also referred to as "NAND-decode status") can be provided to the controller.

In some arrangements, in step 4-7, the controller can read a NAND-decode status, and in step 4-8, the controller can determine whether the HB decoding fails or succeeds. In response to determining that the HB decoding succeeds, in step 4-10, the controller can read out data (e.g., payload only) from the NAND, and bypass decoding on the controller. In response to determining that the HB decoding fails, in step 4-9, the controller can read out full codeword (e.g., payload and redundancy data) from the NAND. In step 4-11, the controller can perform full-capability hard (HB) decoding on the full codeword. For example, the controller can decode the codeword with a different decoder, which has higher complexity and higher decoding capability and/or performs a full-capability decoding.

In some arrangements, a flash memory system can perform patrol read operations using one or more on-die circuits (e.g., ECC circuits and/or on-die read DSP circuits). Exemplary flow for efficient patrol read execution according to embodiments of this invention. In some arrangements, a patrol read for thresholds tracking during idle periods on the storage, can be performed efficiently without requiring any data transfer from NAND to the controller. The goal of patrol reads can be to maintain fresh up-to-date threshold values for all written blocks, in order to avoid read retries, and thus provide highest achievable performance. During the patrol, the threshold tracking may also detect blocks that need refresh, and generate a corresponding status to controller. The controller can schedule block-data refresh after the patrol is completed, for all blocks with high BER status from the patrol. The data refresh can include copying data from a written block that has high BER to a new block (an erased block).

In some arrangements, a fifth process (step 5-1 to step 5-11) for a patrol read flow begins in step 5-1 by starting a patrol read (in a periodic manner). In some arrangements, steps 5-5 to 5-8 can be implemented in or performed by the on-die circuits, while steps 5-1 to 5-4 and 5-9 to 5-11 can be implemented in or performed by a controller of the flash memory system.

In some arrangements, in step 5-2, the controller can hold and maintain a list of written blocks per die that require thresholds refresh. In step 5-3, the controller can examine or check all dies and blocks for patrol read, and for each block, steps 5-4 to 5-10 can be performed. In step 5-4, for all available dies (assuming there are no other higher priority read/write operations), the controller can determine a next block and send a patrol command (e.g., thresholds-tracking command) to the NAND in order to maintain valid read thresholds. The patrol command for a NAND die/block can be a threshold tracking command with HT update for some predetermined block address, and no data can be output from the NAND (except a BER status).

In some arrangements, in step 5-5, the one or more on-die circuits can perform N mock single state reads (e.g., N≥1) with predetermined thresholds (e.g., N predetermined mock thresholds), from a target row. The one or more on-die circuits can read states from the N mock single state reads, into N internal buffers on NAND (e.g., N internal buffers of a memory integrated circuit).

In some arrangements, in step 5-6, the one or more on-die circuits can compute a histogram H of a VT-distribution from all the single state reads. If the one or more on-die circuits performs N mock single state reads, the histogram H can have N+1 states, where the number of states is N+1 due to having performed N single state reads. In some arrangements, for a QLC device, the controller can perform 4 page reads in predetermined mock thresholds locations, and compute a 2⁴=16 state histogram of the target row. It is noted that read size can be even smaller than a full page for computational complexity limitation on NAND.

In some arrangements, in step 5-7, the one or more on-die circuits can estimate target row current thresholds (denoted by "Th") from the histogram H using an estimator (e.g., LUT-based, linear, or DNN-based estimator). The one or more on-die circuits can estimate or classify a BER status (denoted by "BERStatus") as high BER or low BER. In some arrangements, the computed histogram H can be used by another estimator to estimate the BER level or BER status as a classification estimation for identifying high BER that indicates on data refresh requirements. The estimator can return the BERstatus to the one or more on-die circuits, which schedules refresh if needed. The one or more on-die circuits can perform a thresholds tracking and/or a HT update on a mock histogram to estimate current optimal thresholds. In step 5-8, the one or more on-die circuits can receive Th and/or BERStatus as input to an HT-Set operation for a target block, and perform the HT-Set operation.

In some arrangements, in step 5-9, the controller can determine whether the threshold-tracking is completed for scheduled dies and/or blocks. In step 5-10, in response to determining that the threshold-tracking is not completed, the controller can continue to the next block (proceed to step 5-4) with the BERStatus. In some arrangements, the BERstatus can be returned to the controller, which schedules refresh if needed. In some arrangements, the thresholds tracking and HT update operations do not require any decoding and do not transfer any data to the controller. Only the status per block patrol (e.g., BERStatus) can be returned to the controller. In step 5-11, in response to determining that the threshold-tracking is completed, the controller can complete the patrol read.

In some arrangements, a flash memory system can perform a reliable copyback operation using one or more on-die circuits (e.g., ECC circuits and/or on-die read DSP circuits). In some arrangements, the flash memory system can perform a reliable-copyback command which is used for garbage collection or data refresh in NAND based products (e.g. embedded or SSD applications). In some arrangements, a sixth process (step 6-1 to step 6-15) for a copyback flow begins in step 6-1 by receiving a reliable copyback command from page A1, page A2, page A3, page A4 on QLC block A to page B_L (lower page), page B_M (middle page), page B_U (upper page), page B_T (top page) on QLC block B, respectively. In some arrangements, a successful copyback can use all pages A1 to A4, as inputs to program on blocks B. In some arrangements, steps 6-1 to 6-12 can be implemented in or performed by the on-die circuits, while steps 6-13 to 6-15 can be implemented in or performed by a controller of the flash memory system.

In some arrangements, in step 6-2, the one or more on-die circuits can use HT-Get to obtain thresholds to read page Ai (i=1, 2, 3, or 4) into an internal NAND buffer (e.g., NAND buffer of a memory integrated circuit).

In some arrangements, in step 6-3, the one or more on-die circuits can perform hard (HB) decoding on data of page Ai with a low complexity decoder on NAND (e.g., a low complexity decoder of the one or more on-die circuits).

In some arrangements, in step 6-4, the one or more on-die circuits can determine whether the HB decoding succeeds or fails. In some arrangements, in response to determining that the HB decoding succeeds, in step 6-5, the one or more on-die circuits can copy the data of page Ai to another internal NAND buffer (e.g., another NAND buffer of the memory integrated circuit). In step 6-6, the one or more on-die circuits can determine whether decoding of all pages Ai (i=1, 2, 3, and 4) is done. In response to determining that decoding of all pages Ai (i=1, 2, 3, and 4) is not done, the one or more on-die circuits can proceed to step 6-2 to read next page Ai.

In some arrangements, in response to determining that decoding of all pages Ai (i=1, 2, 3, and 4) is done, in step 6-7, the one or more on-die circuits can assign page Ai (i=1, 2, 3, and 4) to L (lower page), M (middle page), U (upper page), T (top page) of the block B and generate a program command. In step 6-8, in response to the program command, the one or more on-die circuits can program page B_L, page B_M, page B_U, page B_T on the block B using page Ai (i=1, 2, 3, and 4), respectively. In step 6-9, the one or more on-die circuits can determine that the reliable copyback operation is done.

In some arrangements, in response to determining that the HB decoding fails, in step 6-10, the one or more on-die circuits can determine whether an internal threshold tracking (e.g., threshold tracking of the one or more on-die circuits) is needed. In some arrangements, in response to determining that an internal threshold tracking is needed, in step 6-11, the one or more on-die circuits can perform NAND internal thresholds tracking. In some arrangements, in response to the controller determining that a thresholds tracking has to be executed, the controller can issue a command for NAND internal thresholds tracking. This command can allow the NAND to compute updated thresholds by using for example a quick threshold tracking (QT) algorithm to estimate the optimal thresholds of a current row. In step 6-11, the one or more on-die circuits can perform the QT by performing a few mock reads with fixed predetermined thresholds, from which a histogram is computed. The histogram can be used for estimating the current thresholds by an estimator. The estimator can be a linear estimator or a DNN based estimator.

In some arrangements, in step 6-12, the one or more on-die circuits can perform HT-Set (e.g., update the history table with thresholds obtained as a result of the internal threshold tracking) and proceed to step 6-2. The one or more on-die circuits can update the computed thresholds (from the internal threshold tracking) by the HT-Set function/operation. The HT-Set function/operation can determine the HT index that points to thresholds table entry with nearest thresholds. The HT-Set function/operation can perform a compression by finding the HT index, for example, with a K-means algorithm. In this manner, the computed thresholds can be used for reading the target page for the second time into the internal page buffer (step 6-2).

In some arrangements, in response to in response to determining that an internal threshold tracking is not needed, in step 6-13, the controller can read out full codeword of page Ai (e.g., payload and redundancy data) from the NAND. In step 6-14, the controller can perform full-capability hard (HB) decoding on the full codeword. For example, the controller can decode the codeword with a different decoder, which has higher complexity and higher decoding capability and/or performs a full-capability decoding. In step 6-14, the controller can write page Ai encoded data from the controller to the NAND internal buffer, and proceed to step 6-6.

In some arrangements, the one or more on-die circuits can perform the reliable copyback by reading from a source block (e.g., QLC block A) its pages (e.g., page A1, page A2, page A3, page A4) in step 6-2. The one or more on-die circuits can perform NAND internal decoding and data correction (step 6-3), and then reprogram the data into a new block (e.g., QLC block B) in steps 6-6 to 6-9. For example, for source block A, the controller can specify the source pages (4 pages on a QLC block), and target page addresses. The sources pages (e.g., page A1, page A2, page A3, page A4) can be read into internal buffers one by one (step 6-2), and can be decoded with the fast-decoder on die (step 6-3). On decode failure, an internal threshold tracking can be activated (steps 6-10, 6-11). Using the updated thresholds (step 6-12), the failed pages can be read again into the same internal buffers (step 6-2) and NAND internal fast-decoding can be performed (step 6-3). If still some pages failed (steps 6-10), then these pages can be output to the controller for full-capability decoding (steps 6-13, 6-14), and returned back to NAND to its internal buffers (step 6-15). Once all decode pages are available (step 6-06), the NAND die (e.g., one or more on-die circuits) can start the program to destination pages (e.g., page B_L, page B_M, page B_U, page B_T on the block B) in steps 6-7 and 6-8, and returns a program status to the controller. In this manner, most of the time the decoding can succeed with the NAND internal decoder, and thus the flash memory system can perform a copyback operation without errors that does not require any data transfer between NAND die and the controller.

A conventional flash memory system (or a controller thereof) performs a copyback operation such that data is read from one block (e.g., read operation using threshold voltages) by the controller, and decoded in the controller, and then transferred back to NAND for programming. For example, for a TLC device, the controller reads (e.g., threshold reads) an upper page, a middle page, and a lower page from a source block, which may incur corresponding read delays (e.g., threshold read delays for the upper page, the middle page, and the lower page), and transfer the pages via a common NAND channel, which may incur corresponding I/O delays for integrated flash controller (IFC) out/in (e.g., I/O delays for the upper page, the middle page, and the lower page). The controller also perform ECC decoding on the data, which may incur corresponding delays (e.g., ECC delays for the upper page, the middle page, and the lower page). The controller also transfers the upper page, the middle page, and the lower page to a destination block via the common NAND channel, and program the corresponding pages to a destination block, which may incur corresponding programming delays.

In some arrangements, one or more on-die circuits can perform a copyback operation such that data is read from one block (e.g., read operation using threshold voltages) by the one or more on-die circuits, and decoded in the one or more on-die circuits, and then transferred back to NAND for programming. For example, for a TLC device, the one or more on-die circuits can read (e.g., threshold reads) an upper page, a middle page, and a lower page from a source block, which may incur corresponding read delays (e.g., threshold read delays for the upper page, the middle page, and the lower page). The one or more on-die circuits also can perform ECC decoding on the data, which may incur corresponding delays (e.g., ECC delays for the upper page, the middle page, and the lower page). The one or more on-die circuits also can program the corresponding pages to a destination block, which may incur corresponding programming delays. In this manner, the one or more on-die circuits (e.g., ECC circuits, read circuits) can have the benefit of on-NAND die implementation for reliable copyback, according to embodiments of this invention. In some arrangements, the one or more on-die circuits can perform the reliable copyback with a on-die decoder which succeeds in decoding the source pages and immediately programs into the destination block. It is shown that the delay incurred in the reliable copyback with on-die circuits (e.g., on-die ECC circuits, on-die read circuits) is significantly shorter than that incurred in the copyback with the conventional controller.

In some arrangements, a flash memory system can perform dynamic inter-cell-interference (ICI) estimation and compensation using one or more on-die circuits (e.g., ECC circuits and/or on-die read DSP circuits). In some arrangements, the system can perform a NAND internal threshold tracking jointly with ICI compensation. In some arrangements, the one or more on-die circuits can estimate the current optimal thresholds for interference compensation. The compensation required may depend on stress conditions. For example under high data-retention, a stronger ICI may occur, which means a different compensation per ICI state.

In some arrangements, a seventh process (step 7-1 to step 7-7) for a ICI estimation/compensation flow begins in step 7-1 by reading a neighbor row (an interference source, e.g., word line WL(n+1)) in a predetermined fixed threshold into an internal buffer. In some arrangements, step 7-1 to step 7-6 can be implemented in or performed by the on-die circuits, while step 7-7 can be implemented in or performed by the controller. In NAND devices, there is usually interference from neighboring cells such as next WL or previous WL. This interference may vary due to stress conditions. For example, under a high retention stress or a high read disturb stress, the ICI effect may be more severe. Therefore, the controller may need to estimate the interference compensation parameters, which means estimating the optimal thresholds per ICI state.

In some arrangements, in step 7-2, the one or more on-die circuits may perform N mock single state reads (N≥1) with predetermined thresholds, from a target row into N internal buffers on NAND. In step 7-3, the one or more on-die circuits may compute a joint histogram H of VT distributions of ICI reads and single state reads. In step 7-4, the one or more on-die circuits may estimate target page read thresholds from the histogram H using at least one of a LUT-based estimator, a linear estimator, or a DNN-based estimator. In step 7-5, the one or more on-die circuits may read a target page using the estimated thresholds according to the number of ICI states. In step 7-6, the one or more on-die circuits may select a per-ICI state of page data according to the read results using thresholds corresponding to the per-ICI state. The selected per-ICI state of page data may be the ICI compensation. In step 7-7, the one or more on-die circuits may determine that the dynamic ICI mitigation is done, and the controller may read (or transfer) data from the NAND.

In some arrangements, when a dynamic-ICI command is issued by the controller, the NAND die (e.g., the one or more on-die circuits) can read the relevant neighboring rows with designated thresholds into its internal buffers (step 7-1). Then, the one or more on-die circuits can read from the target row in the predetermined mock thresholds locations, into different internal buffers (step 7-2). From all internal buffers, a histogram can be computed (step 7-3), and thresholds can be estimated from the histogram for all ICI states (step 7-4). Then, the target row can be read per ICI state with its estimated thresholds (step 7-5), and the data can be transferred to the controller (steps 7-7).

In some arrangements, a flash memory system can perform ICI estimation and compensation and decoding using one or more on-die circuits (e.g., ECC circuits and/or on-die read DSP circuits). In some arrangements, an eighth process (step 8-1 to step 8-12) for an ICI estimation and compensation flow begins in step 8-1 by reading a neighbor row (an interference source, e.g., word line WL(n+1)). In some arrangements, steps 8-1 to 8-7 can be implemented in or performed by the on-die circuits, while steps 8-8 to 8-12 can be implemented in or performed by a controller of the flash memory system.

In some arrangements, in step 8-2, the one or more on-die circuits may perform N mock single state reads (N≥1) with predetermined thresholds, from a target row into N internal buffers on NAND. In step 8-3, the one or more on-die circuits may compute a joint histogram H of VT distributions of ICI reads and single state reads. In step 8-4, the one or more on-die circuits may estimate target page read thresholds from the histogram H using at least one of a LUT-based estimator, a linear estimator, or a DNN-based estimator. In step 8-5, the one or more on-die circuits may read a target page using the estimated thresholds according to the number of ICI states. In step 8-6, the one or more on-die circuits may select a per-ICI state of page data according to the read results using thresholds corresponding to the per-ICI state. The one or more on-die circuits may copy the selected per-ICI state of page data into another internal buffer. The selected per-ICI state of page data may be the ICI compensation. In step 8-7, the one or more on-die circuits may perform HB decoding using a low complexity decoder.

In some arrangements, in step 8-8, the controller can read a NAND-decode status, and in step 8-9, the controller can determine whether the HB decoding fails or succeeds. In response to determining that the HB decoding succeeds, in step 8-11, the controller can read out data (e.g., payload only) from the NAND, and bypass decoding on the controller. In response to determining that the HB decoding fails, in step 8-10, the controller can read out full codeword (e.g., payload and redundancy data) from the NAND. In step 8-12, the controller can perform full-capability hard (HB) decoding on the full codeword. For example, the controller can decode the codeword with a different decoder, which has higher complexity and higher decoding capability and/or performs a full-capability decoding.

In some arrangements, when a dynamic-ICI command is issued by the controller, the NAND die (e.g., one or more on-die circuits) can read the relevant neighboring rows with designated thresholds into its internal buffers (step 8-1). Then the one or more on-die circuits can read from the target row in the predetermined mock thresholds locations, into different internal buffers (step 8-2). From all internal buffers, a histogram can be computed (step 8-3), and thresholds can be estimated from the histogram for all ICI states (step 8-4). Then, the target row can be read per ICI state with its estimated thresholds (step 8-5), and the data can be decoder by the fast-decoder on-die (e.g., a fast decoder of the one or more on-die circuits; step 8-7), and then the data can be transferred to the controller (steps 8-10, 8-11).

According to certain aspects, arrangements in the present disclosure relate to a method for performing operations in a flash memory system including a controller and one or more memory integrated circuits. Each integrated circuit may include a circuit and a non-volatile memory. The non-volatile memory may include one or more blocks, each block comprising a plurality of rows of cells. The method may include performing, by the circuit, a read operation on a page of the non-volatile memory. The method may include decoding, by the circuit, data of the page. The method may include in response to determining that decoding of the data fails, reading, by the controller, the data from the non-volatile memory. The method may include decoding, by the controller, the data.

According to other aspects, arrangements provide a flash memory system including a controller and one or more memory integrated circuits. Each of the one or more memory integrated circuits may include a circuit and a non-volatile memory comprising one or more blocks. Each block may include a plurality of rows of cells. The circuit may be configured to perform operations on the non-volatile memory. The circuit may be configured to perform a read operation on a page of the non-volatile memory. The circuit may be configured to decode data of the page. In response to determining that decoding of the data fails, the controller may be configured to read the data from the non-volatile memory. The controller may be configured to decode the data.

In some arrangements, each memory integrated circuit may include a substrate. The plurality of cells and the circuit may be disposed on the substrate. In some arrangements, the circuit may be bonded to the plurality of cells.

In some arrangements, the circuit may be configured to decode the data based on half-folded product codes (HFPC) using bounded distance decoding (BDD).

In some arrangements, the circuit may be configured to decode the data using a decoding method different from a decoding method used by the controller to decode the data.

In some arrangements, in response to determining that decoding of the data succeeds, the controller may be configured to read payload data of the data from the non-volatile memory. The controller may be configured to transfer the payload data to a host computer without decoding the payload data.

In some arrangements, the one or more memory integrated circuits may include a first memory integrated circuit and a second memory integrated circuit. The circuit of the first memory integrated circuit and the circuit of the second memory integrated circuit are configured to simultaneously perform respective operations on the respective non-volatile memories.

In some arrangements, the non-volatile memory may include a plurality of triple-level cell (TLC) blocks. The circuit may be configured to perform a read operation on an upper page, a middle page, and a lower page of a first TLC block of the plurality of TLC blocks. The circuit may be configured to decode data of the upper page, data of the middle page, and data of the lower page. In response to determining that decoding of the data of the upper page, the data of the middle page, and the data of the lower page succeeds, the circuit may be configured to reprogram the data of the upper page, the data of the middle page, and the data of the lower page into a second TLC block of the plurality of TLC blocks.

In some arrangements, after performing the read operation on the upper page, the circuit may be configured to simultaneously perform the read operation on the middle page and decode the data of the upper page. In some arrangements, after performing the read operation on the middle page, the circuit may be configured to simultaneously perform the read operation on the lower page and decode the data of the middle page.

In some arrangements, the controller may include one or more integrated circuits separate from the one or more memory integrated circuits.

In some arrangements, the circuit may be configured to obtain a row identifier identifying a row of the page, among the plurality of rows. The circuit may be configured to generate, by executing a machine learning model, one or more voltage thresholds for the read operation, based on the row identifier. The circuit may be configured to perform the read operation on the page of the non-volatile memory with the one or more voltage thresholds.

In some arrangements, in response to determining that decoding of the data fails, the circuit may be configured to perform one or more read operations on a target row of the plurality of rows of cells. The circuit may be configured to determine, by executing a machine learning model, one or more voltage thresholds for read operations, based on a result of a result of the one or more read operations. The circuit may be configured to perform the read operation on the page of the non-volatile memory with the one or more voltage thresholds.

In some arrangements, the circuit may be configured to periodically perform a periodic read operation during an idle period on the non-volatile memory. In response to performing the periodic read operation, the circuit may be configured to determine, by executing a machine learning model, one or more voltage thresholds for read operations, based on a result of the periodic read operation. The circuit may be configured to perform the read operation on the page of the non-volatile memory with the one or more voltage thresholds.

Arrangements in the present disclosure have at least the following advantages and benefits. First, arrangements in the present disclosure can sustain, by the use of on-die circuits, write performance improvement of more than 10% via optimized background operations. In some arrangements, the on-die circuits can provide highly efficient support of background programming, for example, performing fast single-level cell (SLC) write, and then folding to triple-level cell (TLC)/quadruple level cells (QLC) blocks with internal decoding and re-encoding on a NAND die. This can have a high power and performance impact.

Second, arrangements in the present disclosure can reduce, by the use of on-die circuits, power on ECC operations and/or read (e.g., read DSP) operations by more than 14% for read operations, and more than 80% for write on power supply voltage VCCQ, by NAND data-out savings (e.g., reducing data out from the NAND dies to the controller).

Third, arrangements in the present disclosure can perform, by the use of on-die circuits, fast ECC for distributed decoding management, which allows read performance improvement of more than 15% by optimized NAND channel utilization. In some arrangements, the use of on-die circuits can improve ECC capability to achieve full read performance under quick-soft decoding, e.g., nearly doubles error correction capability.

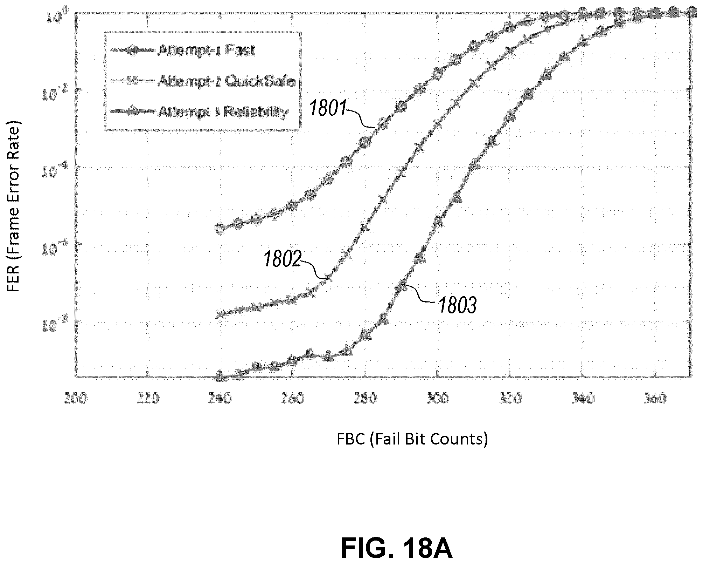

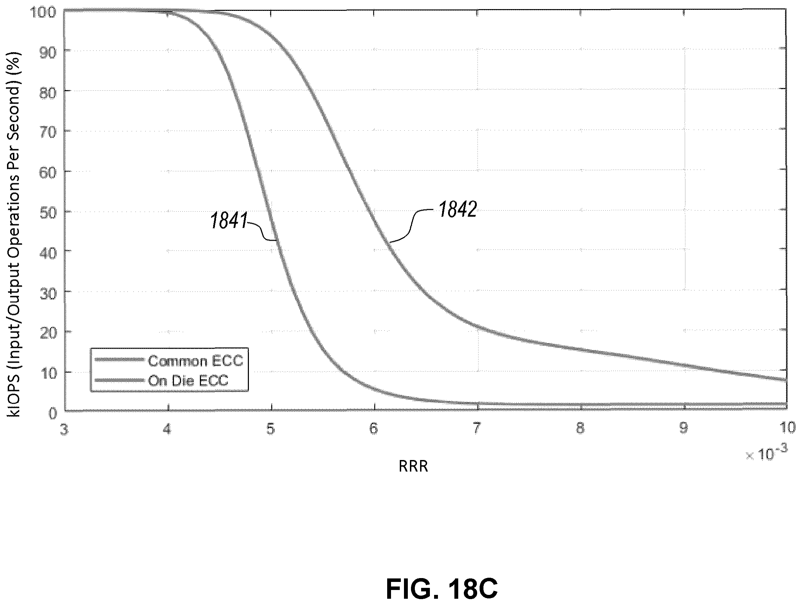

Fourth, arrangements in the present disclosure can include a decoder per NAND die thereby achieving the consistency in latency, compared to a controller that has a single decoder (or just a few) operating at high frequency. In some arrangements, a fast-decoder may be implemented on every NAND die. When a host computer issues many read commands, the flash memory system usually activates all NAND dies. Since the delay for tRead (or threshold read) is usually long relative to the delay for data-transfer on NAND bus or common NAND channel, NAND dies can be simultaneously active during the read. Moreover, if decoding fails, such failure usually involves high latency, and can even reach max-Latency as configured in a decoder. Thus, if only a single decoder is available on the controller only and no decoder is implemented on NAND, in a failure event, all the NAND dies have to wait for completion of decoding for the failed packet. In some arrangements, such failure events can be by either higher complexity decoding (see the curve 1803 "Attempt 3 Reliability" in FIG. 18A) or issuing a threshold tracking command to failed NAND, and then completing the decoding. In some arrangements, when every NAND die has a low complexity decoder, the handling of a single decoder failure of one die does not stall other NAND dies decoding, and thus continuous read and decode can proceed from all dies while the controller handles the failed die to recover its data and continue streaming the decode data to the host. This feature is exemplified in **Fehler! Verweisquelle konnte nicht gefunden werden.** 18B and FIG. 18C.

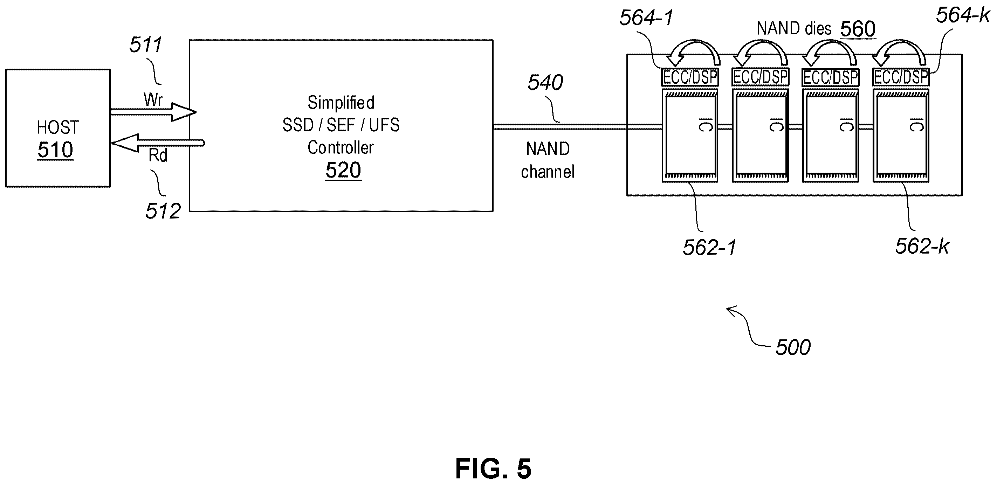

Referring to FIGS. 5-19, arrangements of systems and methods for the present solution to perform operations of a flash memory using on-die circuits (e.g., ECC circuits or read circuits in a memory integrated circuit) are described and illustrated.

FIG. 5 illustrates an example flash memory system 500 including a controller 520 and NAND dies 560 with one or more on-die circuits 564-1, ..., 564-k (k is an integer greater than 0). The flash memory system 500 can include a controller 520 and NAND dies 560 with one or more circuits 564-1, ..., 564-k including one or more ECC circuits and/or one or more read (read DSP) circuits. The flash memory system 500 may include a host 510 (e.g., a computing device), a controller 520, and/or NAND flash memory. The NAND flash memory may include a plurality of NAND dies or a plurality of memory integrated circuits 562-1, ..., 562-k. The plurality of memory integrated circuits 562-1, ..., 562-k can include respective on-die circuits and respective memory (cell) arrays. The host 510 may send commands (e.g., write command 511, read command 512, etc.) to the controller 520, and/or receive a result of commands (e.g., a result of a write operation, or data read from the memory). The controller 520 may include at least one of a SSD controller, a SEF controller, or a UFS controller. The controller 520 may be a simplified controller compared with controllers of a conventional flash device (e.g., controller 420). The on-die circuits (e.g., circuits implemented or disposed in an integrated circuit) can implement DSP capabilities, and/or some ECC functionality. The controller 520 can be connected to the plurality of NAND dies 560 via some common NAND channel 540 (or connection) such that the plurality of NAND dies are connected on the same NAND channel. In some arrangements, the controller 520 can communicate, via the NAND channel 540, with the plurality of dies or memory integrated circuits 562-1, ..., 562-k simultaneously. The NAND channel or connection 540 may be implemented at least one of asynchronous and synchronous interfaces, ONFI, toggle mode DDR, or multiplexed bus. The host 510 can communicate with the controller 520 via a connection including at least one of PCIe, SATA, USB, eMMC, or NVMe.

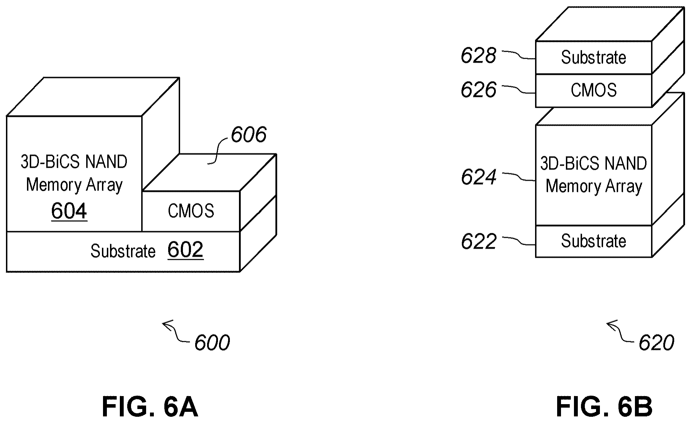

FIG. 6A and FIG. 6B illustrate example memory integrated circuits according to some arrangements. Referring to FIG. 6A, a memory integrated circuit 600 may include a substrate 602, a NAND memory array 604, and/or one or more circuits 606 (e.g., one or more transistors). The substrate 602 can include Si wafers or any substrate that can be used in an integrated circuit. The NAND memory array 604 may include at least one of 3D BiCS NAND memory arrays, CTF NAND memory arrays, floating gate NAND memory arrays, or any NAND memory arrays that can be implemented in an integrated circuit. The one or more circuits 606 may include one or more transistors including at least one of BJT, FET, MOSFET (e.g., NMOS, PMOS, CMOS), FinFET, or any transistor that can be implemented in an integrated circuit. The one or more circuits 606 (or transistors) can implement DSP and ECC logic for performing NAND memory operations. The one or more circuits 606 (or transistors) can include a CMOS die for logic circuit implementation, which can include data latches per plane, sense amplifiers, charge pumps, program logic, trim registers, etc. The CMOS circuit 606 can be manufactured or produced in a different process than the memory array. The one or more circuits 606 (or transistors) and the memory array 604 can be formed or disposed on same substrate 602.

Referring to FIG. 6B, a memory integrated circuit 620 may include a first substrate 622, a NAND memory array 624, a second substrate 628 and/or one or more circuits 626 (e.g., one or more transistors). Each of the first substrate 622 and the second substrate 628 can include Si wafers or any substrate that can be used in an integrated circuit. The NAND memory array 624 may include at least one of 3D-BiCS NAND memory arrays, CTF NAND memory arrays, floating gate NAND memory arrays, or any NAND memory arrays that can be implemented in an integrated circuit. The one or more circuits 626 can include one or more transistors including at least one of BJT, FET, MOSFET (e.g., NMOS, PMOS, CMOS), FinFET, or any transistor that can be implemented in an integrated circuit. The one or more circuits 626 (e.g., CMOS logic circuit) can be bonded to the NAND memory array 624.

As the memory array dimensions change and grow and become 3-dimensional, the CMOS logic can move to be under a vertical stack of memory cells instead of being alongside a NAND memory array. Depending on CMOS process and memory array capacity, more logic can be added to a CMOS circuit without increasing the total NAND memory die area, for example, as long as the CMOS circuit area is smaller than the memory array physical area size. In some arrangements, various logics for NAND operations (e.g., read-DSP and ECC logic) can be added to the NAND die in order to improve overall storage performance, for example, by potentially reducing power and bandwidth requirements on NAND die interface. Referring to FIG. 6B, the one or more circuits 626 (e.g., CMOS logic circuit) can be bonded to the NAND memory array 624 using a technology or method of CMOS directly bonded to array (CBA) based on Cu direct bonding process. In some arrangements, the one or more circuits 626 (e.g., CMOS logic circuit) can be bonded to the NAND memory array 624 using a process of CMOS under Array (CUA). In a CUA process, a memory array can be formed sequentially on CMOS. On the other hand, CBA technology can process both CMOS and cell array, individually.

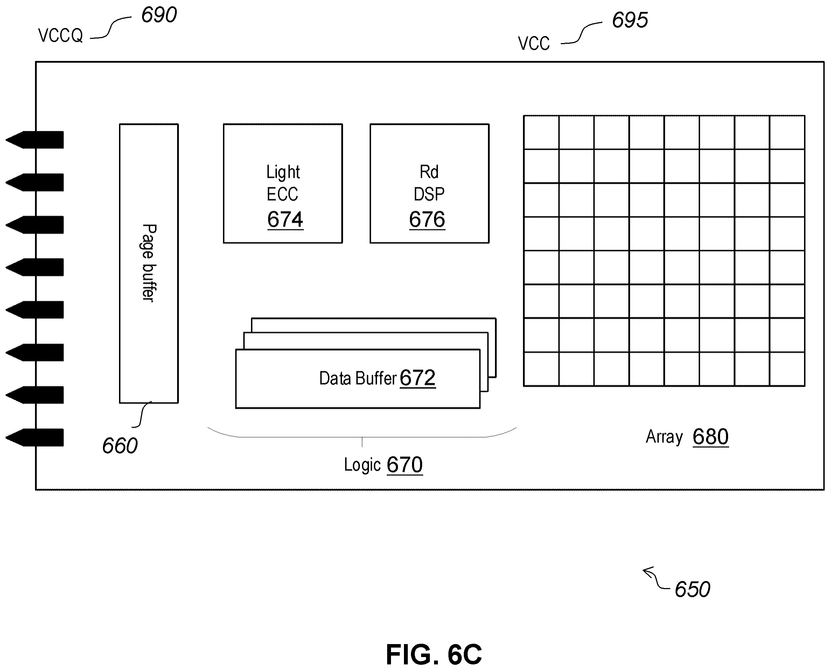

FIG. 6C illustrates an example memory integrated circuit 650 according to some arrangements. The memory integrated circuit 650 may include one or more on-die circuits 670 (logic circuits), a NAND memory array 680, and/or a page buffer 660 (for storing a page of non-volatile memory). The one or more on-die circuits 670 can include at least one of an ECC circuit 674 (or module), a read circuit 676 (e.g., read DSP circuit), and/or a data buffer 672 (for storing data for performing ECC and/or read operations). The ECC circuit 674 can be a simplified, light or partial ECC circuit (or module). The voltage domain VCC 695 can be associated with the memory array and the logic circuit. The voltage domain VCCQ 690 can be associated with interface logic (e.g., output stage logic).

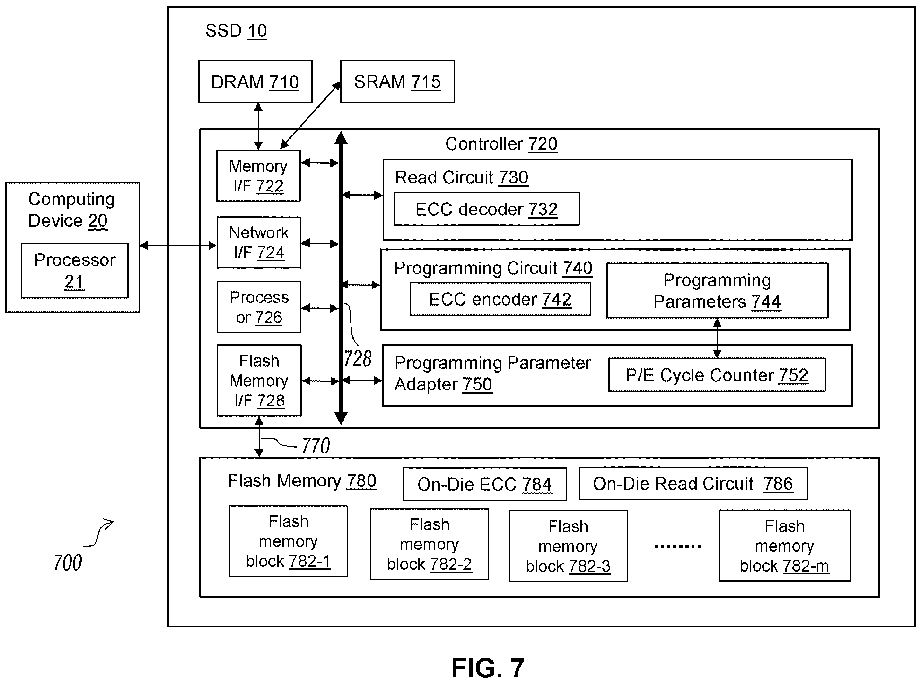

FIG. 7 is a block diagram illustrating an example flash memory system according to some arrangements. Referring to FIG. 7, a flash memory system 700 may include a computing device 20 and a solid-state drive (SSD) 10, which is a storage device and may be used as a main storage of an information processing apparatus (e.g., a host computer). The SSD 10 may be incorporated in the information processing apparatus or may be connected to the information processing apparatus via a cable or a network.

The computing device 20 may be an information processing apparatus (computing device). In some arrangements, the computer device 20 which is configured to handle or process data for training and perform a training a neural network (e.g., DNN 300), and the data for training may be collected from a plurality of SSDs by a plurality of computing devices. The data collected from the plurality of SSDs may be recorded and handled/processed by a different computing device, which is not necessarily connected to any of the SSDs and which performs the training based on the collected data. The computing device 20 includes a processor 21 and/or a database system 26. The database system 26 may store read thresholds values including training sets or results of a training.

The SSD 10 includes, for example, a controller 720 and a flash memory 780 as non-volatile memory (e.g., a NAND type flash memory). The SSD 10 may include a random access memory which is a volatile memory, for example, DRAM (Dynamic Random Access Memory) 710 and/or SRAM (Static Random Access Memory) 715. The random access memory has, for example, a read buffer which is a buffer area for temporarily storing data read out from the flash memory 780, a write buffer which is a buffer area for temporarily storing data written in the flash memory 780, and a buffer used for a garbage collection. In some arrangements, the controller 720 may include DRAM or SRAM.

In some arrangements, the flash memory 780 may include one or more on-die ECC circuits 784, one or more on-die read circuits 786, a memory cell array which includes a plurality of flash memory blocks (e.g., NAND blocks) 782-1 to 782-m. In some arrangements, the flash memory 780 may include one or more memory integrated circuits (e.g., memory ICs 562-1, ..., 562-k in FIG. 5). The one or more memory ICs may include the on-die ECC circuits 784, the on-die read circuits 786, and/or one or more memory cell arrays including the memory blocks 782-1 to 782-m. Each of the blocks 782-1 to 782-m may function as an erase unit. Each of the blocks 782-1 to 782-m includes a plurality of physical pages. In some arrangements, in the flash memory 780, data reading and data writing are executed on a page basis, and data erasing is executed on a block basis.

In some arrangements, the controller 720 may be a memory controller configured to control the flash memory 780. The controller 720 includes, for example, a processor (e.g., CPU) 726, a flash memory interface 728, and a memory interface 722, a network interface 724, all of which may be interconnected via a bus 728. The memory interface 722 may include a DRAM controller configured to control an access to the DRAM 710, and a SRAM controller configured to control an access to the SRAM 715. The flash memory interface 728 may function as a flash memory control circuit (e.g., NAND control circuit) configured to control the flash memory 780 (e.g., NAND type flash memory). The network interface 724 may function as a circuit which receives various data from the computing device 20 and transmits data to the computing device 20. The data may include a plurality of sets of read thresholds or other data collected from the flash memory 780 or a plurality of SSDs for training a neural network (e.g., DNN 300).

The controller 720 may include a read circuit 730, a programming circuit (e.g. a program DSP) 740, and/or a programming parameter adapter 750. As shown in FIG. 7, the adapter 750 can adapt the programming parameters 744 used by programming circuit 740 as described above. The adapter 750 in this example may include a Program/Erase (P/E) cycle counter 752. Although shown separately for ease of illustration, some or all of the adapter 750 can be incorporated in the programming circuit 740. In some arrangements, the read circuit 230 may include an ECC decoder 732 and threshold estimators (e.g., DNN-based R2R estimator, DNN-based FPQT estimator). In some arrangements, the programming circuit 740 may include an ECC encoder 742. Arrangements of memory controller 720 can include additional or fewer components such as those shown in FIG. 7.

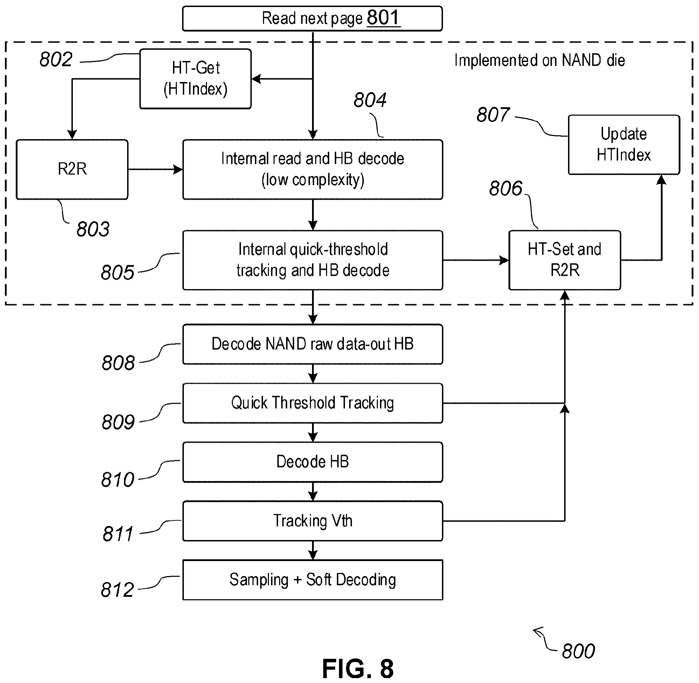

FIG. 8 is a flowchart illustrating an example methodology for performing read operations according to some arrangements. A flash memory system can perform read operations using one or more on-die circuits (e.g., on-die ECC circuits 674, 784 and/or on-die read DSP circuits 676, 786). A process 800 (steps 801 to 8012) for a read flow begins in step 801 by the one or more on-die circuits reading a next page. Steps 801 to step 807 can be implemented in or performed by the on-die circuits, while steps 808 to step 812 can be implemented in or performed by a controller of the flash memory system (e.g., controller 520, 720).

In step 802, the one or more on-die circuits can perform a HT-Get operation to extract a HTIndex (e.g., index to a history table) that keeps the state of the block and points to the type of read on a first stage (e.g., first phase read). In step 803, the one or more on-die circuits can perform an R2R estimator. In step 804, the one or more on-die circuits can perform a read operation and perform hard bit (HB) decoding. For example, when a command of page read is issued from a host, the controller can translate the command physical address, and issue a read and decode command to NAND. The target page can be read into the NAND's internal page buffer. The one or more on-die circuits can activate a fast (HB) decoder. The fast HB decoder can be a low complexity decoder as will be described in the following sections. In response to determining that the decoding succeeds, the NAND (or the one or more on-die circuits) can generate a decode success status to the controller, and the controller can read out the successfully decoded data, without the redundancy bits, which are not needed. In response to determining that the fast decoding fails, the controller may issue an internal tracking command (if the target block did not have updated read thresholds), and in step 805, the one or more on-die circuits can perform quick-training thresholds tracking (QT) on the NAND die to estimate optimal thresholds to the target page. After performing QT, in step 806, the one or more on-die circuits can compute an HTIndex using the HT-Set operation, which can be implemented by a K-means search algorithm. In step 807, the one or more on-die circuits can update the HTIndex. Using the updated thresholds, another read of the target page is performed into an internal NAND page buffer, and the fast HB decoder (of the one or more on-die circuits) can be activated.

In step 805, in response to determining that HB decoding fails, the controller can read raw data (e.g., payload and redundancy data) from NAND. In step 808, the controller can perform HB decoding on the NAND raw data-out (transferred from the NAND). In step 809, if HB decoding fails, then the controller may perform a QT to estimate the optimal thresholds of the current row. The QT may perform a few mock reads with fixed thresholds, from which a histogram is computed. An estimator (e.g., controller, or software, firmware, hardware, or a combination thereof) may use the histogram for estimating the current thresholds. The estimator can be a linear estimator or a DNN based estimator. In step 810, the controller can perform HB decoding. In step 811, if HB decoding fails, then the controller may perform a higher complexity threshold tracking, e.g., pre-soft tracking (PST), followed by sampling and/or soft decoding in step 812.

In step 805, in response to determining that HB decoding succeeds, the NAND (or the one or more on-die circuits) can generate a decode success status to the controller, and the controller can read out the successfully decoded data, without the redundancy bits, which are not needed. in response to determining that the fast decoding fails for the 2^{nd} time, a decoder-fail status can be read by the controller, and the controller can issue a data-out command from NAND to read-out the raw-data including the redundancy bits. Then, in step 808, the controller can activate a higher complexity decoder, which has higher capability, and may decode more errors than the fast-decoder on NAND die (e.g., the one or more on-die circuits). On success, the decoded data can be sent from the controller to the host computer. Otherwise, the controller may activate a higher accuracy thresholds tracking (quick threshold tracking) in step 809. In step 810, the controller can read the target page with updated thresholds and HB decode with full capability on a decoder of the controller. In response to determining that the HB decoding fails, in step 811, the controller may issue and perform an even higher complexity threshold tracking, e.g., pre-soft tracking (PST), followed by soft decoding in step 812.

During every event of threshold tracking (on-die or on controller), an updated set of thresholds for a target row can be computed. The one or more on-die circuits can provide the thresholds as input to HT-Set function on the NAND-die (step 806), which can perform a row-to-row transformation to a common reference row, and then the one or more on-die circuits can compress the thresholds into an HT index that points to closest representative thresholds on HT-table (step 807). The HT index can be updated for the block, and can be used during any page read.

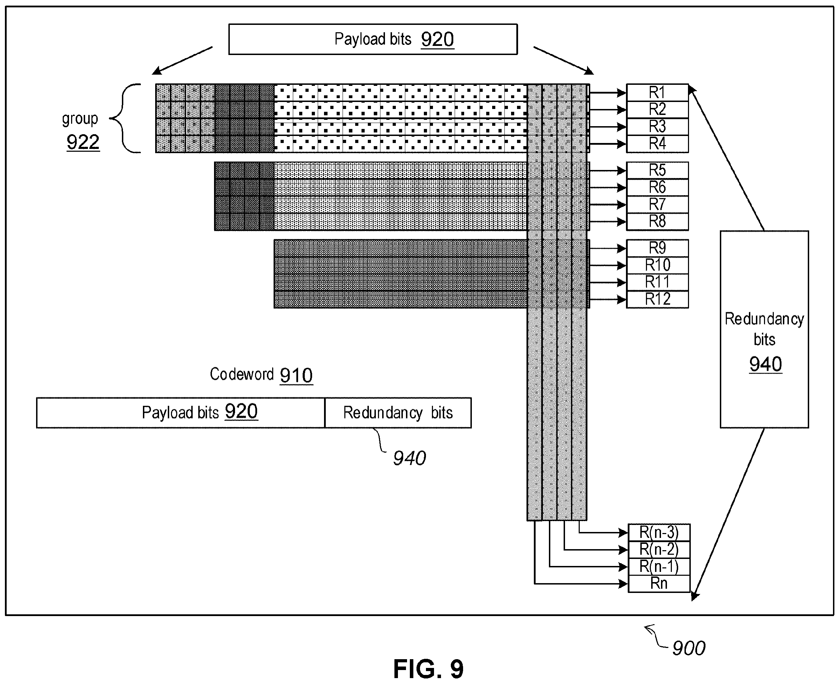

FIG. 9 illustrates an example structure 900 of error correction code (ECC) code, according to some arrangements. One or more on-die circuits (e.g., on-die ECC circuits 674, 784) can use an ECC code structure for half-folded product codes (HFPC) that can be used to encode data written to NAND memory. Each component of the ECC code can be a BCH code that corrects only a few errors, for which a simple low complexity hard decoder can be implemented on NAND-die (as the one or more on-die circuits). In the ECC code structure 900, payload bits 920 can be divided into a plurality of groups (e.g., group 922). For each group, redundancy bits can be generated. For example, given the payload bits 920, n number of redundance bits R1, R2, ..., Rn (940) can be generated, and a codeword 910 can include the payload bits 920 concatenated by the redundancy bits 940.

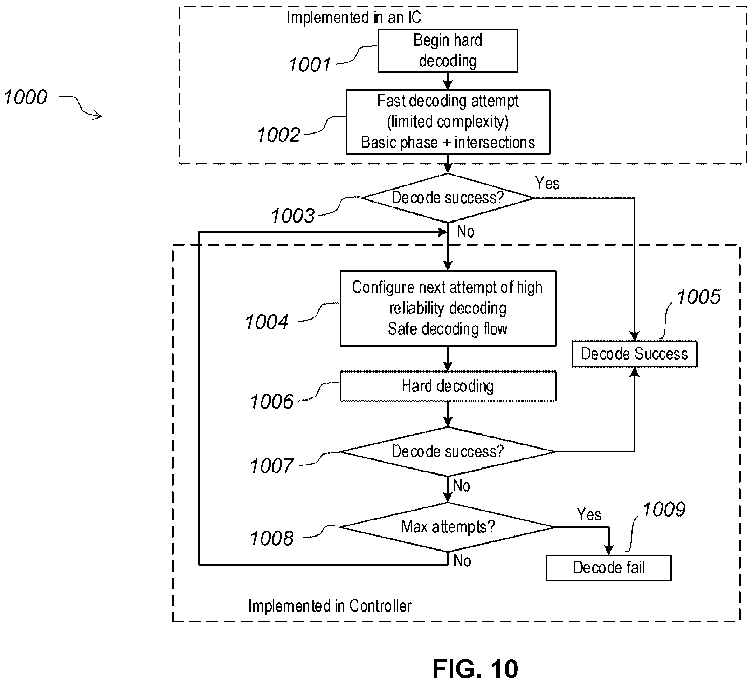

FIG. 10 is a flowchart illustrating an example methodology for performing read operations using on-die circuits (e.g., on-die ECC circuits 674, 784 and/or on-die read DSP circuits 676, 786 in a memory integrated circuit), according to some arrangements. A flash memory system can perform HB decoding of a single codeword using one or more on-die circuits (e.g., on-die ECC circuits 674, 784 and/or on-die read DSP circuits 676, 786). A process 1000 for a read flow (steps 1001 to 1009) begins in step 1001 by performing HB decoding. In step 1002, the one or more on-die circuits can perform fast decoding (with limited complexity) on basic phase with intersections. HB decoding of a single codeword can be implemented in a combination of NAND (e.g., on-die circuits) and the controller of the flash memory system. The one or more on-die circuits can perform decoding of a codeword on NAND die, using a low complexity fast decoding algorithm, such as BDD, but not limited thereto. For example, a more advanced intersections decoding may also be implemented on NAND (e.g., as an on-die ECC circuit) to provide improved capability under limited implementation complexity and latency limitations. Steps 1001 to 1003 can be implemented in or performed by the on-die circuits, while steps 1004 to 1009 can be implemented in or performed by a controller of the flash memory system (e.g., controller 520, 720).

In step 1003, the on-die circuits can determine whether the (fast) decoding fails or succeeds. In response to determining that the (fast) decoding fails, the controller can read raw data (e.g., payload and redundancy data) from NAND. For example, in case the decoding fails, the original (row) data (e.g., payload and redundancy data) from the NAND buffer can be transferred to the controller.

In response to determining that the (fast) decoding succeeds, in step 1005, the controller can determine that the decoding succeeds. When decoding succeeds, the corrected data (payload only) can be transferred from NAND to the controller, and the controller can transfer the data to a host computer without having to process the data on the decoder, as it contains no errors.

In step 1004, in response to reading the raw data from the on-die circuits, the controller can configure the next attempt of decoding as high reliability decoding (or safe decoding). The controller can perform higher complexity decoding, and may apply more than one decoding attempts, until decoding succeeds, or a maximal number of attempts is reached. It is noted that during the decoding operation in the controller, other NAND dies (e.g., the one or more on-die circuits) can continue decoding with their fast-decoders, and continue transferring clean payload data to the controller, while the controller is still decoding its input from a failed die.

In step 1005, the controller can perform HB decoding. In step 1006, the controller can determine whether the HB decoding fails or succeeds. In response to determining that the HB decoding succeeds, in step 1006, the controller can determine that the decoding succeeds. In response to determining that the HB decoding fails, in step 1007, the controller can determine whether the number of attempts reaches a predetermined maximum number of attempts. In response to determining that the number of attempts reaches the predetermined maximum number, in step 1009, the controller can determine that decoding fails and end the process 1000. In response to determining that the number of attempts is less than the predetermined maximum number, the controller can proceed to step 1004. In this manner, an algorithmic (e.g., algorithm for perform HB decoding of a single codeword) can be split between a NAND-die decoder (e.g., on-die ECC circuit) and a controller decoder (e.g., ECC circuit in the controller), which allows higher complexity decoding flows.

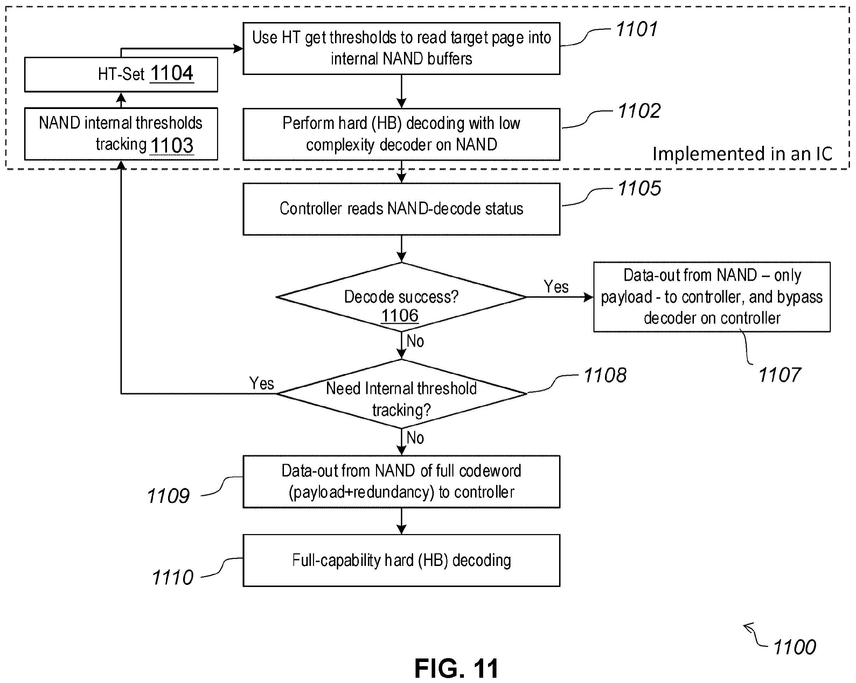

FIG. 11 is a flowchart illustrating another example methodology for performing read operations using on-die circuits, according to some arrangements. A flash memory system can perform reliable page read operations using one or more on-die circuits (e.g., on-die ECC circuits 674, 784 and/or on-die read DSP circuits 676, 786). A process 1100 (step 1101 to step 1110) for a read flow begins in step 1101 by using HT-Get to obtain thresholds to read a target page into internal NAND buffers. The controller can request from NAND a reliable read command for a certain page (or smaller segment). The page can be read into internal NAND buffers (e.g., internal NAND buffers of a memory integrated circuit) while using threshold provided by the HT-Get function/operation. The HT-Get operation refers to an operation of extracting thresholds from a history table. For each block, there is a pointer called "HT index" that selects the corresponding current thresholds. These can be thresholds of a reference (common) row, which can be translated to the target row. This can be done with a row-to-row (R2R) estimator. The estimator may be same for all stresses, or may be optimized per stress condition which is associated with HT index.

Steps 1101 to 1104 can be implemented in or performed by the on-die circuits, while steps 1105 to 1110 can be implemented in or performed by a controller of the flash memory system (e.g., controller 520, 720).

In step 1102, the one or more on-die circuits can perform HB decoding with a low complexity (fast) decoder on NAND (e.g., low complexity decoder of the one or more on-die circuits). The page data in the internal NAND buffer can be decoded with the low complexity (fast) decoder. When decoding ends, a decode status (also referred to as "NAND-decode status") can be provided to the controller.

In step 1105, the controller can read a NAND-decode status, and in step 1106, the controller can determine whether the HB decoding fails or succeeds. In response to determining that the HB decoding succeeds, the controller can read out data (e.g., payload only) from the NAND, and bypass decoding on the controller. In response to determining that the HB decoding fails, in step 1108, the controller can determine whether an internal threshold tracking (e.g. threshold tracking performed by the one or more on-die circuits) is needed. In response to the NAND-decode status indicating a success status, the NAND can send or transfer the corrected data (payload only) to the controller.

In response to determining that an internal threshold tracking is needed, in step 1103, the one or more on-die circuits can perform NAND internal thresholds tracking. In response to the controller determining that a thresholds tracking has to be executed, the controller can issue a command for NAND internal thresholds tracking. This command can allow the NAND to compute updated thresholds by using for example a quick threshold tracking (QT) algorithm to estimate the optimal thresholds of a current row. In step 1103, the one or more on-die circuits can perform the QT by performing a few mock reads with fixed predetermined thresholds, from which a histogram is computed. The histogram can be used for estimating the current thresholds by an estimator. The estimator can be a linear estimator or a DNN based estimator.

In step 1104, the one or more on-die circuits can perform HT-Set (e.g., update the history table with thresholds obtained as a result of the internal threshold tracking) and proceed to step 1101. The one or more on-die circuits can update the computed thresholds (from the internal threshold tracking) by the HT-Set function/operation. The HT-Set function/operation can determine the HT index that points to thresholds table entry with nearest thresholds. The HT-Set function/operation can perform a compression by finding the HT index, for example, with a K-means algorithm. In this manner, the computed thresholds can be used for reading the target page for the second time into the internal page buffer (step 1101).

In response to determining that an internal threshold tracking is not needed, in step 1109, the controller can read out data or a full codeword (e.g., payload and redundancy data) from the NAND. In step 1110, the controller can perform full-capability hard (HB) decoding on the full codeword. On a decode fail status (in step 1106), for the second time, in response to determining that the controller does not send a tracking command, in step 1109, the controller can read the raw data as was read into internal buffer payload and redundancy, and, in step 1110, decode the codeword with a different decoder, which has higher complexity and higher decoding capability and/or performs a full-capability decoding.

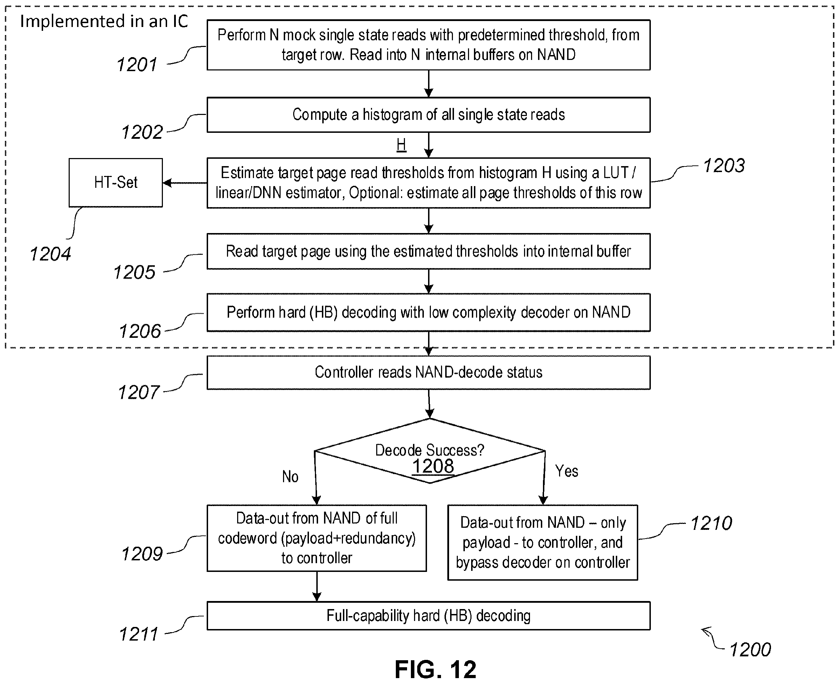

FIG. 12 is a flowchart illustrating yet another example methodology for performing read operations using on-die circuits, according to some arrangements. A flash memory system can perform optimal thresholds read operations and decoding using one or more on-die circuits (e.g., on-die ECC circuits 674, 784 and/or on-die read DSP circuits 676, 786). A process 1200 (step 1201 to step 1211) for an optimal thresholds read flow begins in step 1201 by performing N mock signal state reads with predetermined thresholds, from a target row. The one or more on-die circuits can read states from the N mock signal state reads into N internal buffers on NAND (e.g., N internal buffers of a memory integrated circuit). Steps 1201 to 1210 can be implemented in or performed by the on-die circuits, while step 1211 can be implemented in or performed by a controller of the flash memory system (e.g., controller 520, 720).

The controller can issue a command for a NAND internal thresholds tracking. In response to the command, in step 1201, the one or more on-die circuits can compute updated thresholds by using, for example, a quick threshold tracking (QT) algorithm to estimate the optimal thresholds of a current row. The one or more on-die circuits can perform thresholds tracking estimation by (1) performing N single-state reads using N-predetermined mock threshold, and (2) reading single states from the N single-state reads, and storing the single states in N separate NAND internal buffers (e.g., N NAND internal buffers of a memory integrated circuit).

In step 1202, the one or more on-die circuits can compute a joint histogram H of VT distributions of all single state reads. From N the NAND internal buffers, the one or more on-die circuits can compute a histogram with N+1 states, denoted by H, where the number of states is N+1 due to having performed N single state reads. The one or more on-die circuits for QLC device can perform 4 page reads in predetermined mock thresholds locations, and compute a 2^4=16 state histogram of the target row. The read size can be even smaller than a full page for computational complexity limitation on NAND.

In step 1203, the one or more on-die circuits may estimate target page read thresholds from the histogram H to predict optimal thresholds using at least one of (1) a linear estimator, (2) a deep neural network (DNN)-based estimator, or (3) a LUT-based estimator. The linear (precomputed) estimator can extract optimal row thresholds using Equation 8.

The DNN-based estimator can provide higher accuracy (e.g., than the linear estimator) at the price of higher computational complexity. The LUT-based estimator can be a direct simple solution that can map the histogram values to an HT index in a history table (also referred to as "HT table") to select a threshold set from the history table.

In step 1204, the one or more on-die circuits can provide the estimated thresholds as input to HT-Set function on the NAND-die (e.g., HT-Set function implemented in the one or more on-die circuits). Once the thresholds are estimated, the one or more on-die circuits can update the HT table index with the estimated thresholds by using the HT-Set function, which performs R2R and selection of index HT index that corresponds to thresholds that are closest to estimated thresholds (e.g., using K-means search). The HT-Set function can determine the HT index that points to thresholds table entry with nearest thresholds. The HT-Set function can perform a compression by finding the HT index, for example, with a K-means algorithm. In step 1205, the one or more on-die circuits may read a target page using the estimated thresholds into internal buffers on NAND (e.g., internal buffers of a memory integrated circuit). The computed (or estimated) thresholds can be used for reading the target page for the second time into an internal page buffer (e.g., an internal page buffer of a memory integrated circuit).

In step 1206, the one or more on-die circuits can perform HB decoding with a low complexity (fast) decoder on NAND (e.g., low complexity decoder of the one or more on-die circuits). The page data in the internal NAND buffer can be decoded with the low complexity (fast) decoder. When decoding ends, a decode status (also referred to as "NAND-decode status") can be provided to the controller.

In step 1207, the controller can read a NAND-decode status, and in step 1208, the controller can determine whether the HB decoding fails or succeeds. In response to determining that the HB decoding succeeds, in step 1210, the controller can read out data (e.g., payload only) from the NAND, and bypass decoding on the controller. In response to determining that the HB decoding fails, in step 1209, the controller can read out full codeword (e.g., payload and redundancy data) from the NAND. In step 1211, the controller can perform full-capability hard (HB) decoding on the full codeword. For example, the controller can decode the codeword with a different decoder, which has higher complexity and higher decoding capability and/or performs a full-capability decoding.

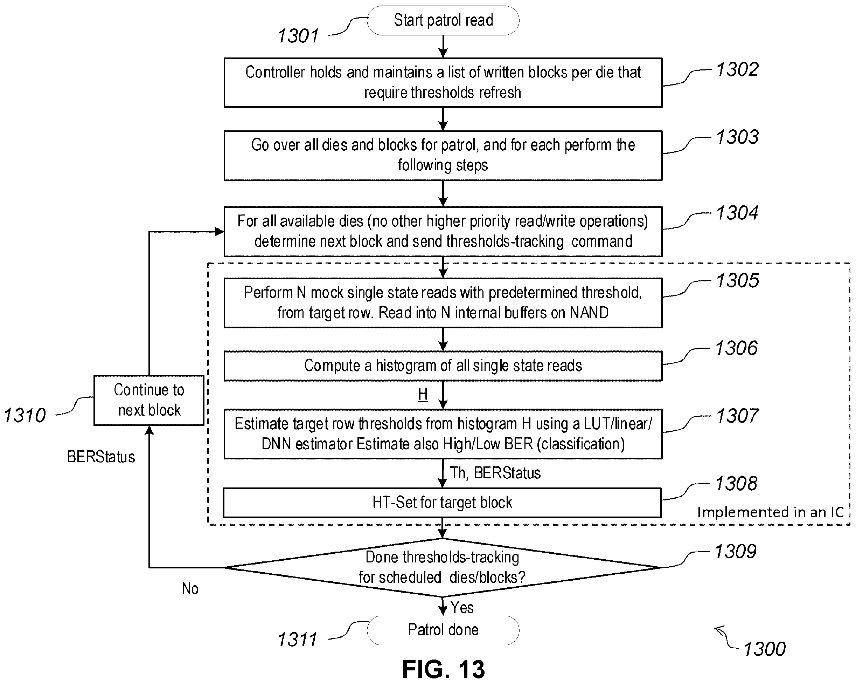

FIG. 13 is a flowchart illustrating an example methodology for performing a patrol read using on-die circuits, according to some arrangements. A flash memory system can perform patrol read operations using one or more on-die circuits (e.g., on-die ECC circuits 674, 784 and/or on-die read DSP circuits 676, 786). Exemplary flow for efficient patrol read execution according to embodiments of this invention. A patrol read for thresholds tracking during idle periods on the storage, can be performed efficiently without requiring any data transfer from NAND to the controller. The goal of patrol reads can be to maintain fresh up-to-date threshold values for all written blocks, in order to avoid read retries, and thus provide highest achievable performance. During the patrol, the threshold tracking may also detect blocks that need refresh, and generate a corresponding status to controller. The controller can schedule block-data refresh after the patrol is completed, for all blocks with high BER status from the patrol. The data refresh can include copying data from a written block that has high BER to a new block (an erased block).

A process 1300 (step 1301 to step 1311) for a patrol read flow begins in step 1301 by starting a patrol read (in a periodic manner). Steps 1305 to 1308 can be implemented in or performed by the on-die circuits, while steps 1301 to 1304 and 1309 to 1311 can be implemented in or performed by a controller of the flash memory system (e.g., controller 520, 720).

In step 1302, the controller can hold and maintain a list of written blocks per die that require thresholds refresh. In step 1303, the controller can examine or check all dies and blocks for patrol read, and for each block, steps 1304 to 1310 can be performed. In step 1304, for all available dies (assuming there are no other higher priority read/write operations), the controller can determine a next block and send a patrol command (e.g., thresholds-tracking command) to the NAND in order to maintain valid read thresholds. The patrol command for a NAND die/block can be a threshold tracking command with HT update for some predetermined block address, and no data can be output from the NAND (except a BER status).

In step 1305, the one or more on-die circuits can perform N mock single state reads (e.g., N≥1) with predetermined thresholds (e.g., N predetermined mock thresholds), from a target row. The one or more on-die circuits can read states from the N mock single state reads, into N internal buffers on NAND (e.g., N internal buffers of a memory integrated circuit).

In step 1306, the one or more on-die circuits can compute a histogram H of a VT-distribution from all the single state reads. If the one or more on-die circuits performs N mock single state reads, the histogram H can have N+1 states, where the number of states is N+1 due to having performed N single state reads. For a QLC device, the controller can perform 4 page reads in predetermined mock thresholds locations, and compute a 2⁴=16 state histogram of the target row. It is noted that read size can be even smaller than a full page for computational complexity limitation on NAND.

In step 1307, the one or more on-die circuits can estimate target row current thresholds (denoted by "Th") from the histogram H using an estimator (e.g., LUT-based, linear, or DNN-based estimator). The one or more on-die circuits can estimate or classify a BER status (denoted by "BERStatus") as high BER or low BER. The computed histogram H can be used by another estimator to estimate the BER level or BER status as a classification estimation for identifying high BER that indicates on data refresh requirements. The estimator can return the BERstatus to the one or more on-die circuits, which schedules refresh if needed. The one or more on-die circuits can perform a thresholds tracking and/or a HT update on a mock histogram to estimate current optimal thresholds. In step 1308, the one or more on-die circuits can receive Th and/or BERStatus as input to an HT-Set operation for a target block, and perform the HT-Set operation.

In step 1309, the controller can determine whether the threshold-tracking is completed for scheduled dies and/or blocks. In step 1310, in response to determining that the threshold-tracking is not completed, the controller can continue to the next block (proceed to step 1304) with the BERStatus. The BERstatus can be returned to the controller, which schedules refresh if needed. The thresholds tracking and HT update operations do not require any decoding and do not transfer any data to the controller. Only the status per block patrol (e.g., BERStatus) can be returned to the controller. In step 1311, in response to determining that the threshold-tracking is completed, the controller can complete the patrol read.

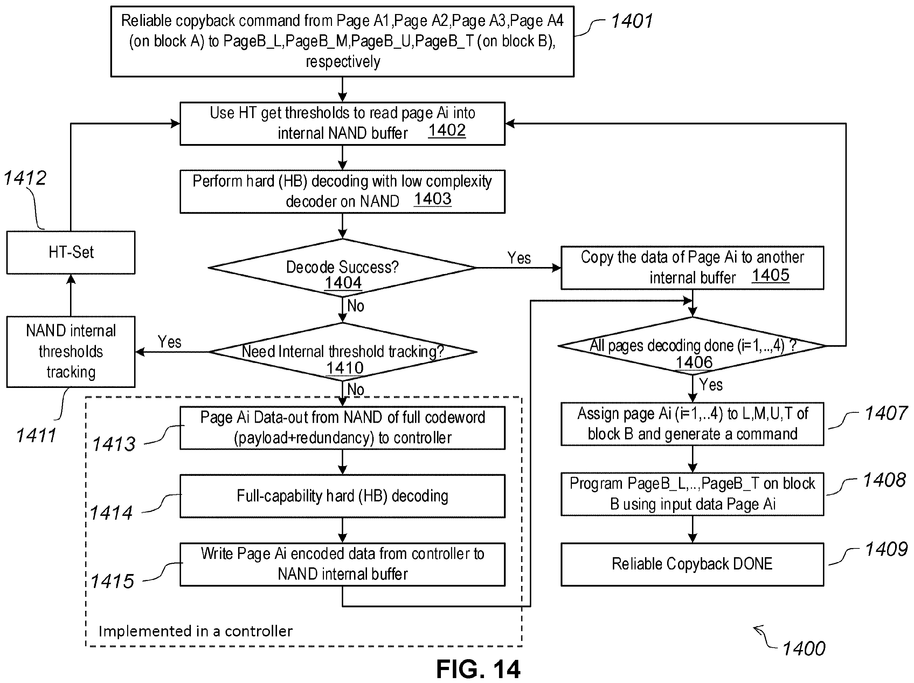

FIG. 14 is a flowchart illustrating another example methodology for performing a copyback operation using on-die circuits, according to some arrangements, according to some arrangements. A flash memory system can perform a reliable copyback operation using one or more on-die circuits (e.g., on-die ECC circuits 674, 784 and/or on-die read DSP circuits 676, 786). The flash memory system can perform a reliable-copyback command which is used for garbage collection or data refresh in NAND based products (e.g. embedded or SSD applications). A process 1400 (step 1401 to step 1415) for a copyback flow begins in step 1401 by receiving a reliable copyback command from page A1, page A2, page A3, page A4 on QLC block A to page B_L (lower page), page B_M (middle page), page B_U (upper page), page B_T (top page) on QLC block B, respectively. Steps 1401 to 1412 can be implemented in or performed by the on-die circuits, while steps 1413 to 1415 can be implemented in or performed by a controller of the flash memory system (e.g., controller 520, 720).

In step 1402, the one or more on-die circuits can use HT-Get to obtain thresholds to read page Ai (i=1, 2, 3, or 4) into an internal NAND buffer (e.g., NAND buffer of a memory integrated circuit).

In step 1403, the one or more on-die circuits can perform hard (HB) decoding on data of page Ai with a low complexity decoder on NAND (e.g., a low complexity decoder of the one or more on-die circuits).

In step 1404, the one or more on-die circuits can determine whether the HB decoding succeeds or fails. In response to determining that the HB decoding succeeds, in step 1405, the one or more on-die circuits can copy the data of page Ai to another internal NAND buffer (e.g., another NAND buffer of the memory integrated circuit). In step 1406, the one or more on-die circuits can determine whether decoding of all pages Ai (i=1, 2, 3, and 4) is done. In response to determining that decoding of all pages Ai (i=1, 2, 3, and 4) is not done, the one or more on-die circuits can proceed to step 1402 to read next page Ai.

In response to determining that decoding of all pages Ai (i=1, 2, 3, and 4) is done, in step 1407, the one or more on-die circuits can assign page Ai (i=1, 2, 3, and 4) to L (lower page), M (middle page), U (upper page), T (top page) of the block B and generate a program command. In step 1408, in response to the program command, the one or more on-die circuits can program page B_L, page B_M, page B_U, page B_T on the block B using page Ai (i=1, 2, 3, and 4), respectively. In step 1409, the one or more on-die circuits can determine that the reliable copyback operation is done.

In response to determining that the HB decoding fails, in step 1410, the one or more on-die circuits can determine whether an internal threshold tracking (e.g., threshold tracking of the one or more on-die circuits) is needed. In response to determining that an internal threshold tracking is needed, in step 1411, the one or more on-die circuits can perform NAND internal thresholds tracking. In response to the controller determining that a thresholds tracking has to be executed, the controller can issue a command for NAND internal thresholds tracking. This command can allow the NAND to compute updated thresholds by using for example a quick threshold tracking (QT) algorithm to estimate the optimal thresholds of a current row. In step 1411, the one or more on-die circuits can perform the QT by performing a few mock reads with fixed predetermined thresholds, from which a histogram is computed. The histogram can be used for estimating the current thresholds by an estimator. The estimator can be a linear estimator or a DNN based estimator.

In step 1412, the one or more on-die circuits can perform HT-Set (e.g., update the history table with thresholds obtained as a result of the internal threshold tracking) and proceed to step 1402. The one or more on-die circuits can update the computed thresholds (from the internal threshold tracking) by the HT-Set function/operation. The HT-Set function/operation can determine the HT index that points to thresholds table entry with nearest thresholds. The HT-Set function/operation can perform a compression by finding the HT index, for example, with a K-means algorithm. In this manner, the computed thresholds can be used for reading the target page for the second time into the internal page buffer (step 1402).

In response to in response to determining that an internal threshold tracking is not needed, in step 1413, the controller can read out full codeword of page Ai (e.g., payload and redundancy data) from the NAND. In step 1414, the controller can perform full-capability hard (HB) decoding on the full codeword. For example, the controller can decode the codeword with a different decoder, which has higher complexity and higher decoding capability and/or performs a full-capability decoding. In step 1414, the controller can write page Ai encoded data from the controller to the NAND internal buffer, and proceed to step 1406.

The one or more on-die circuits can perform the reliable copyback by reading from a source block (e.g., QLC block A) its pages (e.g., page A1, page A2, page A3, page A4) in step 1402. The one or more on-die circuits can perform NAND internal decoding and data correction (step 1403), and then reprogram the data into a new block (e.g., QLC block B) in steps 1406 to 1409. For example, for source block A, the controller can specify the source pages (4 pages on a QLC block), and target page addresses. The sources pages (e.g., page A1, page A2, page A3, page A4) can be read into internal buffers one by one (step 1402), and can be decoded with the fast-decoder on die (step 1403). On decode failure, an internal threshold tracking can be activated (steps 1410, 1411). Using the updated thresholds (step 1412), the failed pages can be read again into the same internal buffers (step 1402) and NAND internal fast-decoding can be performed (step 1403). If still some pages failed (steps 1410), then these pages can be output to the controller for full-capability decoding (steps 1413, 1414), and returned back to NAND to its internal buffers (step 1415). Once all decode pages are available (step 1406), the NAND die (e.g., one or more on-die circuits) can start the program to destination pages (e.g., page B_L, page B_M, page B_U, page B_T on the block B) in steps 1407 and 1408, and returns a program status to the controller. In this manner, most of the time the decoding can succeed with the NAND internal decoder, and thus the flash memory system can perform a copyback operation without errors that does not require any data transfer between NAND die and the controller.

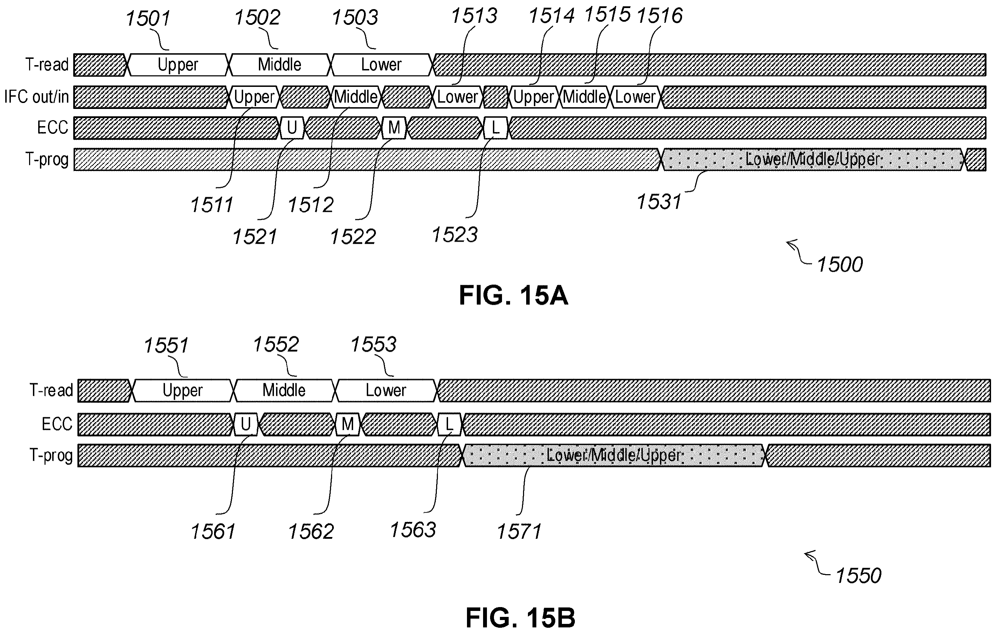

FIG. 15A and FIG. 15B are timing diagrams 1500, 1550 illustrating timing of copyback operations using on-die circuits, according to some arrangements. Referring to FIG. 15A, a conventional flash memory system (or a controller thereof) performs a copyback operation such that data is read from one block (e.g., read operation using threshold voltages) by the controller, and decoded in the controller, and then transferred back to NAND for programming. For example, for a TLC device, the controller reads (e.g., threshold reads or T-read) an upper page, a middle page, and a lower page from a source block, which may incur corresponding read delays (e.g., threshold read delays 1501, 1502, 1503 for the upper page, the middle page, and the lower page), and transfer the pages via a common NAND channel, which may incur corresponding I/O delays for integrated flash controller (IFC) out/in (e.g., I/O delays 1511, 1512, 1513 for the upper page, the middle page, and the lower page). The controller also perform ECC decoding on the data, which may incur corresponding delays (e.g., ECC delays 1521, 1522, 1523 for the upper page, the middle page, and the lower page). The controller also transfers the upper page, the middle page, and the lower page to a destination block via the common NAND channel, which may incur corresponding delays (e.g., IFC delays 1514, 1515, 1516 for the upper page, the middle page, and the lower page), and program the corresponding pages to a destination block, which may incur corresponding programming delays (e.g., programming delay 1531).

Referring to FIG. 15B, one or more on-die circuits can perform a copyback operation such that data is read from one block (e.g., read operation using threshold voltages) by the one or more on-die circuits, and decoded in the one or more on-die circuits, and then transferred back to NAND for programming. For example, for a TLC device, the one or more on-die circuits can read (e.g., threshold reads) an upper page, a middle page, and a lower page from a source block, which may incur corresponding read delays (e.g., threshold read delays 1551, 1552, 1553 for the upper page, the middle page, and the lower page). The one or more on-die circuits also can perform ECC decoding on the data, which may incur corresponding delays (e.g., ECC delays 1561, 1562, 1563 for the upper page, the middle page, and the lower page). The one or more on-die circuits also can program the corresponding pages to a destination block, which may incur corresponding programming delays (e.g., programming delay 1571). In this manner, the one or more on-die circuits (e.g., ECC circuits, read circuits) can have the benefit of on-NAND die implementation for reliable copyback, according to embodiments of this invention. The one or more on-die circuits can perform the reliable copyback with a on-die decoder which succeeds in decoding the source pages and immediately programs into the destination block. It is shown that the delay incurred in the reliable copyback with on-die circuits (e.g., on-die ECC circuits 674, 784 and/or on-die read DSP circuits 676, 786) as shown in FIG. 15B is significantly shorter than that incurred in the copyback with the conventional controller as shown in FIG. 15A.

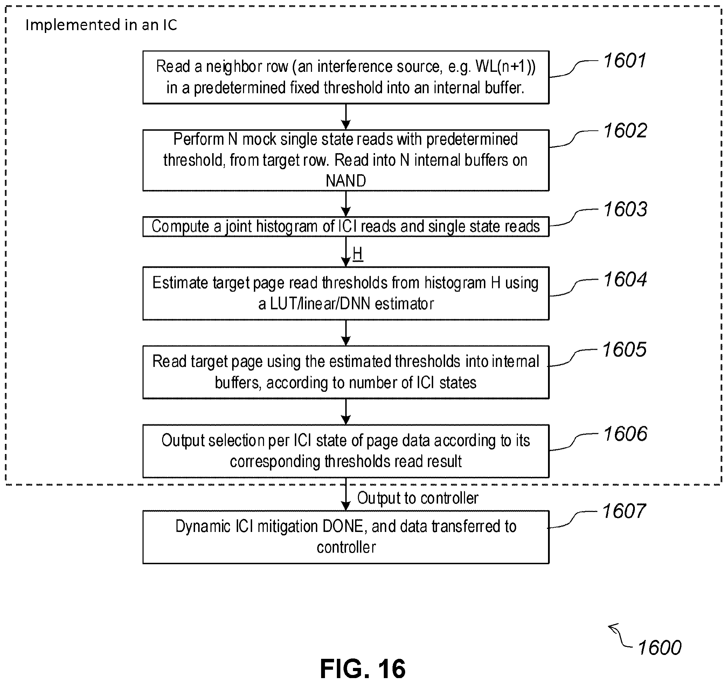

FIG. 16 is a flowchart illustrating another example methodology for dynamic inter-cell-interference (ICI) estimation and compensation, according to some arrangements. A flash memory system can perform dynamic ICI estimation and compensation using one or more on-die circuits (e.g., on-die ECC circuits 674, 784 and/or on-die read DSP circuits 676, 786). The system can perform a NAND internal threshold tracking jointly with ICI compensation. The one or more on-die circuits can estimate the current optimal thresholds for interference compensation. The compensation required may depend on stress conditions. For example under high data-retention, a stronger ICI may occur, which means a different compensation per ICI state.

A process 1600 (step 1601 to step 1607) for a ICI estimation/compensation flow begins in step 1601 by reading a neighbor row (an interference source, e.g., word line WL(n+1)) in a predetermined fixed threshold into an internal buffer. Step 1601 to step 1606 can be implemented in or performed by the on-die circuits, while step 1607 can be implemented in or performed by the controller. In NAND devices, there is usually interference from neighboring cells such as next WL or previous WL. This interference may vary due to stress conditions. For example, under a high retention stress or a high read disturb stress, the ICI effect may be more severe. Therefore, the controller may need to estimate the interference compensation parameters, which means estimating the optimal thresholds per ICI state.

In step 1602, the one or more on-die circuits may perform N mock single state reads (N≥1) with predetermined thresholds, from a target row into N internal buffers on NAND. In step 1603, the one or more on-die circuits may compute a joint histogram H of VT distributions of ICI reads and single state reads. In step 1604, the one or more on-die circuits may estimate target page read thresholds from the histogram H using at least one of a LUT-based estimator, a linear estimator, or a DNN-based estimator. In step 1605, the one or more on-die circuits may read a target page using the estimated thresholds according to the number of ICI states. In step 1606, the one or more on-die circuits may select a per-ICI state of page data according to the read results using thresholds corresponding to the per-ICI state. The selected per-ICI state of page data may be the ICI compensation. In step 1607, the one or more on-die circuits may determine that the dynamic ICI mitigation is done, and the controller may read (or transfer) data from the NAND.

When a dynamic-ICI command is issued by the controller, the NAND die (e.g., the one or more on-die circuits) can read the relevant neighboring rows with designated thresholds into its internal buffers (step 1601). Then, the one or more on-die circuits can read from the target row in the predetermined mock thresholds locations, into different internal buffers (step 1602). From all internal buffers, a histogram can be computed (step 1603), and thresholds can be estimated from the histogram for all ICI states (step 1604). Then, the target row can be read per ICI state with its estimated thresholds (step 1605), and the data can be transferred to the controller (steps 1607).

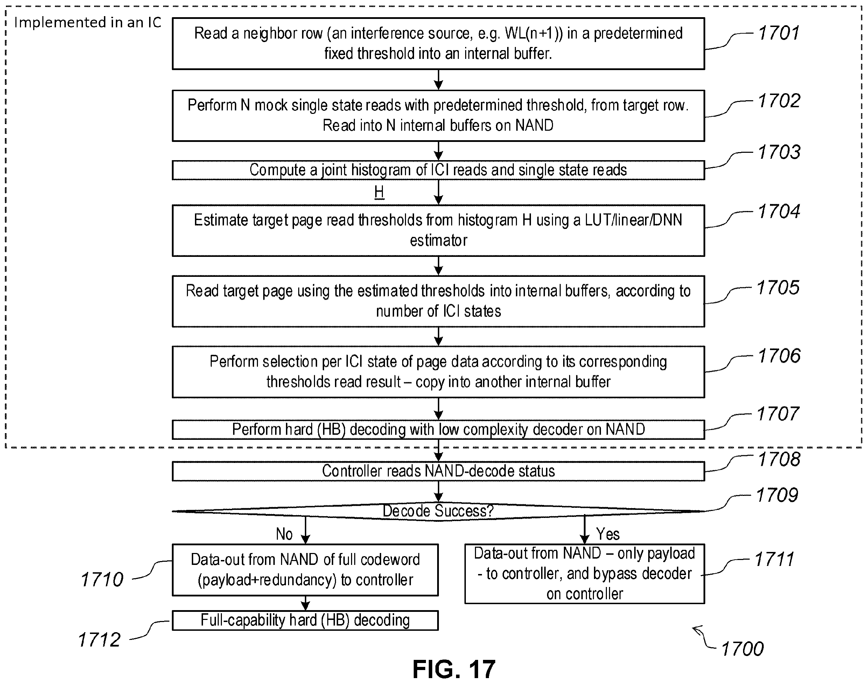

FIG. 17 is a flowchart illustrating an example methodology for dynamic inter-cell-interference (ICI) estimation and compensation using on-die circuits, according to some arrangements. A flash memory system can perform ICI estimation and compensation and decoding using one or more on-die circuits (e.g., on-die ECC circuits 674, 784 and/or on-die read DSP circuits 676, 786). A process 1700 (step 1701 to step 1712) for an ICI estimation and compensation flow begins in step 1701 by reading a neighbor row (an interference source, e.g., word line WL(n+1)). Steps 1701 to 1707 can be implemented in or performed by the on-die circuits, while steps 1708 to 1712 can be implemented in or performed by a controller of the flash memory system (e.g., controller 520, 720).

In step 1702, the one or more on-die circuits may perform N mock single state reads (N≥1) with predetermined thresholds, from a target row into N internal buffers on NAND. In step 1703, the one or more on-die circuits may compute a joint histogram H of VT distributions of ICI reads and single state reads. In step 1704, the one or more on-die circuits may estimate target page read thresholds from the histogram H using at least one of a LUT-based estimator, a linear estimator, or a DNN-based estimator. In step 1705, the one or more on-die circuits may read a target page using the estimated thresholds according to the number of ICI states. In step 1706, the one or more on-die circuits may select a per-ICI state of page data according to the read results using thresholds corresponding to the per-ICI state. The one or more on-die circuits may copy the selected per-ICI state of page data into another internal buffer. The selected per-ICI state of page data may be the ICI compensation. In step 1707, the one or more on-die circuits may perform HB decoding using a low complexity decoder.

In step 1708, the controller can read a NAND-decode status, and in step 1709, the controller can determine whether the HB decoding fails or succeeds. In response to determining that the HB decoding succeeds, in step 1711, the controller can read out data (e.g., payload only) from the NAND, and bypass decoding on the controller. In response to determining that the HB decoding fails, in step 1710, the controller can read out full codeword (e.g., payload and redundancy data) from the NAND. In step 1712, the controller can perform full-capability hard (HB) decoding on the full codeword. For example, the controller can decode the codeword with a different decoder, which has higher complexity and higher decoding capability and/or performs a full-capability decoding.

When a dynamic-ICI command is issued by the controller, the NAND die (e.g., one or more on-die circuits) can read the relevant neighboring rows with designated thresholds into its internal buffers (step 1701). Then the one or more on-die circuits can read from the target row in the predetermined mock thresholds locations, into different internal buffers (step 1702). From all internal buffers, a histogram can be computed (step 1703), and thresholds can be estimated from the histogram for all ICI states (step 1704). Then, the target row can be read per ICI state with its estimated thresholds (step 1705), and the data can be decoder by the fast-decoder on-die (e.g., a fast decoder of the one or more on-die circuits; step 1707), and then the data can be transferred to the controller (steps 1710, 1711).

FIG. 18A to FIG. 18C illustrate diagrams illustrating example simulation results of performance of a flash memory system using on-die circuits, according to some arrangements. FIG. 18A illustrates a diagram illustrating example results of an exemplary HB ECC decoder capability for a TLC code rate, according to some arrangements. The curve 1801 (referred to as "Attempt-1 Fast") indicates an empirical FER (frame error rate) over FBC (frame bit counts) evaluated using a fast-decoding method (like BDD). The curve 1802 (referred to as "Attempt-2 Quick Safe") indicates an empirical FER over FBC evaluated using a quick safe-decoding method as described above. The curve 1803 (referred to as "Attempt-3 reliability") indicates an empirical FER over FBC evaluated using a reliability decoding method as described above.

The simulation curve 1801 called "Attempt-1 Fast" indicates that capability may be achieved with a fast-decoding method (like BDD) as described above. In some arrangements, a fast-decoder that implements a BDD like hard-decoder for product codes like HFPC codes may be implemented on NAND-die as a building block of the full decoder (e.g., as the one or more on-die circuits). The simulation curve 1802 called "Attempt-2 QuickSafe" and the simulation curve 1802 called "Attempt-3 Reliability" can be associated with the quick safe-decoding method and the reliability decoding method, respectively. In some arrangements, the quick safe-decoding method and the reliability decoding method may be implemented on the controller, for cases that NAND-die decoding failed due to a high error rate. The additional capability of these decoders can compensate for the limited complexity decoder included in every NAND die.

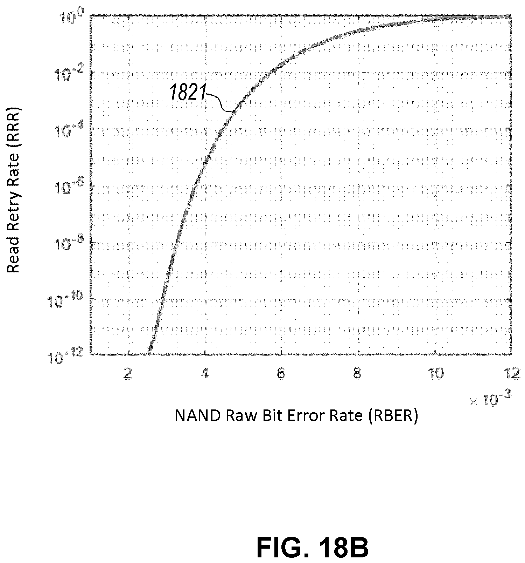

FIG. 18B illustrates a diagram illustrating example results of the read retry rate (RRR) as function of the NAND input bit error rate (BER). The curve 1821 represents the decoder capability as function of input BER distribution.

FIG. 18C illustrates a diagram illustrating example results of the achievable read performance for random read in relative kIOPS (Input/Output Operations Per Second). That is, 100% indicates the full performance, and 50% indicates that performance IOPS drop to half. The achievable read performance in kIOPS is simulated as function of the RRR. The curve 1841 shows the read performance of a conventional single decoder which is referred to as "common ECC". The curve 1842 shows the read performance of on-die ECC decoder per NAND die, which is referred to as "On die ECC". The simulation results show that using per NAND die decoders enable maintaining higher read performance for a higher RRR conditions compared to the case of a single decoder.

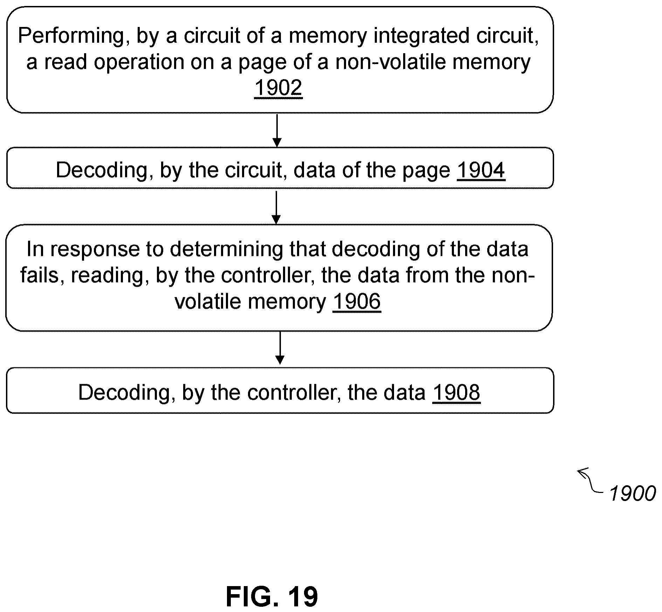

FIG. 19 is a flowchart illustrating an example methodology for performing operations of a flash memory using circuits in memory integrated circuits (or on-die circuits), according to some arrangements. In some arrangements, the example methodology relates to a process 1900 executed or performed by a flash memory system (e.g., flash memory system 700), a circuit of the flash memory system (e.g., read circuit 730, programming circuit 740, programming parameter adapter 750), or on-die circuits of the flash memory system (e.g., on-die circuits 564, 606, 626, 674, 676, 784, 786). The flash memory system may include a controller (e.g., controller 720) and one or more memory integrated circuits (e.g., ICs 562-1, ..., 562-k). Each of the one or more memory integrated circuits may include a circuit (e.g., ECC/Read circuits 564-1, ..., 564-k) and a non-volatile memory (e.g., flash memory 780) comprising one or more blocks (e.g., blocks 782-1, ..., 782-m). Each block may include a plurality of rows of cells. The circuit (e.g., ECC/Read circuits 564-1, ..., 564-k, on-die circuits 606, 626, 674, 676, 784, 786) may perform operations on the non-volatile memory.

In some arrangements, each memory integrated circuit (e.g., ICs 600, 620, 650) may include a substrate (e.g., substrates 602, 622, 628). The plurality of cells (e.g., memory array 604) and the circuit (e.g., CMOS 606) may be disposed on the substrate (e.g., substrate 602). In some arrangements, the circuit (e.g., CMOS 626) may be bonded to the plurality of cells (e.g., memory array 624). In some arrangements, the controller (e.g., controller 520, 720) may include one or more integrated circuits separate from the one or more memory integrated circuits.

In some arrangements, the one or more memory integrated circuits may include a first memory integrated circuit (e.g., memory IC 562-1) and a second memory integrated circuit (e.g., memory IC 562-2). The circuit of the first memory integrated circuit and the circuit of the second memory integrated circuit are configured to simultaneously perform respective operations on the respective non-volatile memories.

In this example, the process 1900 begins in step S1902 by the circuit performing a read operation on a page of the non-volatile memory (e.g., step 1101). In step S1904, in some arrangements, the circuit may decode data of the page (e.g., step 1102). In some arrangements, the circuit may be configured to decode the data based on half-folded product codes (HFPC) using bounded distance decoding (BDD).

In step S1906, in some arrangements, in response to determining that decoding of the data fails, the controller may read the data from the non-volatile memory (e.g., steps 1105, 1107, 1109).

In step S1908, in some arrangements, in response to receiving the data from the circuit, the controller may decode the data (e.g., step 1110). In some arrangements, the circuit may be configured to decode the data using a decoding method (e.g., BDD) different from a decoding method used by the controller to decode the data (e.g., reliability decoding or quick safe-decoding method).

In some arrangements, in response to determining that decoding of the data succeeds, the controller may be configured to read payload data of the data from the non-volatile memory (e.g., step 1107). The controller may be configured to transfer the payload data to a host computer (e.g., host 20, 510) without decoding the payload data.

In some arrangements, the non-volatile memory may include a plurality of triple-level cell (TLC) blocks. The circuit may be configured to perform a read operation on an upper page, a middle page, and a lower page (e.g., reads of an upper page 1551, a middle page 1552, and a lower page 1553) of a first TLC block of the plurality of TLC blocks. The circuit may be configured to decode data of the upper page, data of the middle page, and data of the lower page (e.g., decoding of the upper page 1561, the middle page 1562, and the lower page 1563). In response to determining that decoding of the data of the upper page, the data of the middle page, and the data of the lower page succeeds, the circuit may be configured to reprogram the data of the upper page, the data of the middle page, and the data of the lower page (e.g., reprogram 1571 of the upper page, the middle page, and the lower page) into a second TLC block of the plurality of TLC blocks.

In some arrangements, after performing the read operation on the upper page (e.g., read operation 1551), the circuit may be configured to simultaneously perform the read operation on the middle page (e.g., read operation 1552) and decode the data of the upper page (e.g., decoding operation 1561). In some arrangements, after performing the read operation on the middle page (e.g., read operation 1552), the circuit may be configured to simultaneously perform the read operation on the lower page (e.g., read operation 1553) and decode the data of the middle page (e.g., decode operation 1562).

In some arrangements, the circuit may be configured to obtain a row identifier identifying a row of the page, among the plurality of rows (e.g., R2R operation in step 803). The circuit may be configured to generate, by executing a machine learning model, one or more voltage thresholds for the read operation, based on the row identifier. The circuit may be configured to perform the read operation on the page of the non-volatile memory with the one or more voltage thresholds.

In some arrangements, in response to determining that decoding of the data fails, the circuit may be configured to perform one or more read operations on a target row of the plurality of rows of cells (e.g., step 1201). The circuit may be configured to determine, by executing a machine learning model, one or more voltage thresholds for read operations, based on a result of a result of the one or more read operations (e.g., steps 1202, 1203). The circuit may be configured to perform the read operation on the page of the non-volatile memory with the one or more voltage thresholds (e.g., step 1205).

In some arrangements, the circuit may be configured to periodically perform a periodic read operation during an idle period on the non-volatile memory (e.g., step 1301). In response to performing the periodic read operation, the circuit may be configured to determine, by executing a machine learning model, one or more voltage thresholds for read operations, based on a result of the periodic read operation (e.g., steps 1305, 1306, 1307). The circuit may be configured to perform the read operation on the page of the non-volatile memory with the one or more voltage thresholds.

The previous description is provided to enable any person skilled in the art to practice the various aspects described herein. Various modifications to these aspects will be readily apparent to those skilled in the art, and the generic principles defined herein may be applied to other aspects. Thus, the claims are not intended to be limited to the aspects shown herein, but is to be accorded the full scope consistent with the language claims, wherein reference to an element in the singular is not intended to mean "one and only one" unless specifically so stated, but rather "one or more." Unless specifically stated otherwise, the term "some" refers to one or more. All structural and functional equivalents to the elements of the various aspects described throughout the previous description that are known or later come to be known to those of ordinary skill in the art are expressly incorporated herein by reference and are intended to be encompassed by the claims. Moreover, nothing disclosed herein is intended to be dedicated to the public regardless of whether such disclosure is explicitly recited in the claims. No claim element is to be construed as a means plus function unless the element is expressly recited using the phrase "means for."

It is understood that the specific order or hierarchy of steps in the processes disclosed is an example of illustrative approaches. Based upon design preferences, it is understood that the specific order or hierarchy of steps in the processes may be rearranged while remaining within the scope of the previous description. The accompanying method claims present elements of the various steps in a sample order, and are not meant to be limited to the specific order or hierarchy presented.

The previous description of the disclosed implementations is provided to enable any person skilled in the art to make or use the disclosed subject matter. Various modifications to these implementations will be readily apparent to those skilled in the art, and the generic principles defined herein may be applied to other implementations without departing from the spirit or scope of the previous description. Thus, the previous description is not intended to be limited to the implementations shown herein but is to be accorded the widest scope consistent with the principles and novel features disclosed herein.

The various examples illustrated and described are provided merely as examples to illustrate various features of the claims. However, features shown and described with respect to any given example are not necessarily limited to the associated example and may be used or combined with other examples that are shown and described. Further, the claims are not intended to be limited by any one example.

The foregoing method descriptions and the process flow diagrams are provided merely as illustrative examples and are not intended to require or imply that the steps of various examples must be performed in the order presented. As will be appreciated by one of skill in the art the order of steps in the foregoing examples may be performed in any order. Words such as "thereafter," "then," "next," etc. are not intended to limit the order of the steps; these words are simply used to guide the reader through the description of the methods. Further, any reference to claim elements in the singular, for example, using the articles "a," "an" or "the" is not to be construed as limiting the element to the singular.

The various illustrative logical blocks, modules, circuits, and algorithm steps described in connection with the examples disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present disclosure.

The hardware used to implement the various illustrative logics, logical blocks, modules, and circuits described in connection with the examples disclosed herein may be implemented or performed with a general purpose processor, a DSP, an ASIC, an FPGA or other programmable logic device, discrete gate or transistor logic, discrete hardware components, or any combination thereof designed to perform the functions described herein. A general-purpose processor may be a microprocessor, but, in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration. Alternatively, some steps or methods may be performed by circuitry that is specific to a given function.

In some exemplary examples, the functions described may be implemented in hardware, software, firmware, or any combination thereof. If implemented in software, the functions may be stored as one or more instructions or code on a non-transitory computer-readable storage medium or non-transitory processor-readable storage medium. The steps of a method or algorithm disclosed herein may be embodied in a processor-executable software module which may reside on a non-transitory computer-readable or processor-readable storage medium. Non-transitory computer-readable or processor-readable storage media may be any storage media that may be accessed by a computer or a processor. By way of example but not limitation, such non-transitory computer-readable or processor-readable storage media may include RAM, ROM, EEPROM, FLASH memory, CD-ROM or other optical disk storage, magnetic disk storage or other magnetic storage devices, or any other medium that may be used to store desired program code in the form of instructions or data structures and that may be accessed by a computer. Disk and disc, as used herein, includes compact disc (CD), laser disc, optical disc, digital versatile disc (DVD), floppy disk, and blu-ray disc where disks usually reproduce data magnetically, while discs reproduce data optically with lasers. Combinations of the above are also included within the scope of non-transitory computer-readable and processor-readable media. Additionally, the operations of a method or algorithm may reside as one or any combination or set of codes and/or instructions on a non-transitory processor-readable storage medium and/or computer-readable storage medium, which may be incorporated into a computer program product.

The preceding description of the disclosed examples is provided to enable any person skilled in the art to make or use the present disclosure. Various modifications to these examples will be readily apparent to those skilled in the art, and the generic principles defined herein may be applied to some examples without departing from the spirit or scope of the disclosure. Thus, the present disclosure is not intended to be limited to the examples shown herein but is to be accorded the widest scope consistent with the following claims and the principles and novel features disclosed herein.

## Claims

1. A flash memory system comprising:
a controller; and
one or more memory integrated circuits, each of the one or more memory integrated circuits comprising:
a non-volatile memory comprising one or more blocks, each block comprising a plurality of rows of cells, and
a circuit configured to:
perform a read operation on a page of the non-volatile memory; and
decode data of the page,
wherein in response to determining that decoding of the data fails, the controller is configured to read the data from the non-volatile memory and decode the data.

2. The flash memory system of claim 1, wherein each memory integrated circuit further comprises:
a substrate,
wherein the plurality of cells and the circuit are disposed on the substrate.

3. The flash memory system of claim 1, wherein the circuit is bonded to the plurality of cells.

4. The flash memory system of claim 1, wherein the circuit is configured to decode the data based on half-folded product codes (HFPC) using bounded distance decoding (BDD).

5. The flash memory system of claim 1, wherein
the circuit is configured to decode the data using a decoding method different from a decoding method used by the controller to decode the data.

6. The flash memory system of claim 1, wherein
in response to determining that decoding of the data succeeds, the controller is configured to:
read payload data of the data from the non-volatile memory, and
transfer the payload data to a host computer without decoding the payload data.

7. The flash memory system of claim 1, wherein
the one or more memory integrated circuits comprise a first memory integrated circuit and a second memory integrated circuit, and
the circuit of the first memory integrated circuit and the circuit of the second memory integrated circuit are configured to simultaneously perform respective operations on the respective non-volatile memories.

8. The flash memory system of claim 1, wherein
the non-volatile memory comprise a plurality of triple-level cell (TLC) blocks, and
the circuit is configured to:
perform a read operation on an upper page, a middle page, and a lower page of a first TLC block of the plurality of TLC blocks;
decode data of the upper page, data of the middle page, and data of the lower page; and
in response to determining that decoding of the data of the upper page, the data of the middle page, and the data of the lower page succeeds, reprogram the data of the upper page, the data of the middle page, and the data of the lower page into a second TLC block of the plurality of TLC blocks.

9. The flash memory system of claim 8, wherein
after performing the read operation on the upper page, the circuit is configured to simultaneously perform the read operation on the middle page and decode the data of the upper page, or
after performing the read operation on the middle page, the circuit is configured to simultaneously perform the read operation on the lower page and decode the data of the middle page.

10. The flash memory system of claim 1, wherein the controller comprises one or more integrated circuits separate from the one or more memory integrated circuits.

11. A method for performing operations in a flash memory system comprising a controller and one or more memory integrated circuits,
each integrated circuit comprising: a circuit and a non-volatile memory comprising one or more blocks, each block comprising a plurality of rows of cells, the method comprising:
performing, by the circuit, a read operation on a page of the non-volatile memory;
decoding, by the circuit, data of the page;
in response to determining that decoding of the data fails, reading, by the controller, the data from the non-volatile memory; and
decoding, by the controller, the data.

12. The method of claim 11, wherein the circuit decodes the data based on half-folded product codes (HFPC) using bounded distance decoding (BDD).

13. The method of claim 11, wherein
the circuit decodes the data using a decoding method different from a decoding method used by the controller to decode the data.

14. The method of claim 11, further comprising:
in response to determining that decoding of the data succeeds, reading, by the controller, payload data of the data from the non-volatile memory, and
transferring, by the controller, the payload data to a host computer without decoding the payload data.

15. The method of claim 11, further comprising:
simultaneously performing, by a first memory integrated circuit and a second memory integrated circuit of the one or more memory integrated circuits, respective operations on the respective non-volatile memories.

16. The method of claim 11, wherein
the non-volatile memory comprise a plurality of triple-level cell (TLC) blocks, and
the method comprises:
performing, by the circuit, a read operation on an upper page, a middle page, and a lower page of a first TLC block of the plurality of TLC blocks;
decoding, by the circuit, data of the upper page, data of the middle page, and data of the lower page; and
in response to determining that decoding of the data of the upper page, the data of the middle page, and the data of the lower page succeeds, reprogramming, by the circuit, the data of the upper page, the data of the middle page, and the data of the lower page into a second TLC block of the plurality of TLC blocks.

17. The method of claim 16, further comprising:
after performing the read operation on the upper page, simultaneously performing, by the circuit, the read operation on the middle page and decoding of the data of the upper page, or
after performing the read operation on the middle page, simultaneously performing, by the circuit, the read operation on the lower page and decoding of the data of the middle page.

18. The method of claim 11, further comprising:
obtaining, by the circuit, a row identifier identifying a row of the page, among the plurality of rows;
generating, by the circuit executing a machine learning model, one or more voltage thresholds for the read operation, based on the row identifier; and
performing, by the circuit, the read operation on the page of the non-volatile memory with the one or more voltage thresholds.

19. The method of claim 11, further comprising:
in response to determining that decoding of the data fails, performing, by the circuit, one or more read operations on a target row of the plurality of rows of cells;
determining, by the circuit executing a machine learning model, one or more voltage thresholds for read operations, based on a result of a result of the one or more read operations; and
performing, by the circuit, the read operation on the page of the non-volatile memory with the one or more voltage thresholds.

20. The method of claim 11, further comprising:
periodically performing, by the circuit, a periodic read operation during an idle period on the non-volatile memory; and
in response to performing the periodic read operation, determining, by the circuit executing a machine learning model, one or more voltage thresholds for read operations, based on a result of the periodic read operation; and
performing, by the circuit, the read operation on the page of the non-volatile memory with the one or more voltage thresholds.
